(19) Europäisches Patentamt
European Patent Office
Office européen des brevets

(11) EP 4 763 945 A1

(12) **EUROPEAN PATENT APPLICATION**

(43) Date of publication:
**24.06.2026 Bulletin 2026/26**

(21) Application number: **24221740.4**

(22) Date of filing: **19.12.2024**

(51) International Patent Classification (IPC):
***C09K 11/06*** (2006.01) ***H10K 50/11*** (2023.01)
***H10K 85/30*** (2023.01) ***H10K 85/60*** (2023.01)

(52) Cooperative Patent Classification (CPC):
**C09K 11/06; H10K 85/6572;** H10K 50/16; H10K 50/171; H10K 85/654

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Novaled GmbH**
**01099 Dresden (DE)**

(72) Inventors:
- **KARPOV, Yevhen**
  **01099 Dresden (DE)**
- **HUANG, Qiang**
  **01099 Dresden (DE)**
- **STENNETT, Thomas**
  **01099 Dresden (DE)**
- **GALÁN GARCÍA, Elena**
  **01099 Dresden (DE)**

(74) Representative: **Erbacher, Martin**
**Boehmert & Boehmert**
**Anwaltspartnerschaft mbB**
**Pettenkoferstrasse 22**
**80336 München (DE)**

(54) **ORGANIC ELECTRONIC DEVICE, DISPLAY DEVICE AND COMPOUND**

(57) The present invention relates to an organic electronic device, a display device comprising the same and to a compound.

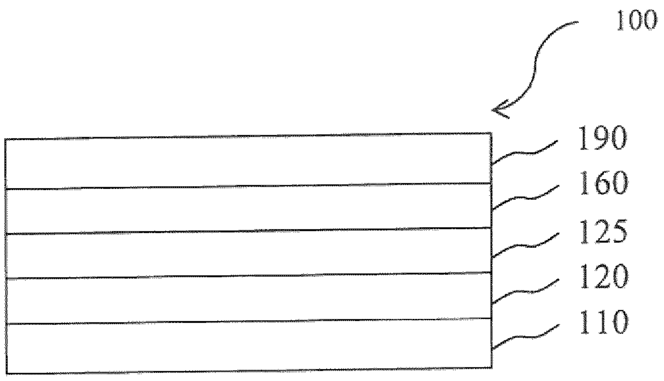


Fig.1

EP 4 763 945 A1

**Description**

TECHNICAL FIELD

The present invention relates to an organic electronic device and to a display device comprising the same. The present invention relates further to a compound.

BACKGROUND OF THE INVENTION

Organic semiconducting devices, such as organic light-emitting diodes OLEDs, which are self-emitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

Performance of an organic light emitting diode may be affected by characteristics of the organic semiconductor layer, and among them, may be affected by characteristics of an organic material of the organic semiconductor layer.

Particularly, development of an organic semiconductor layer being capable of increasing electron mobility and simultaneously increasing electrochemical stability is needed so that the organic semiconducting device, such as an organic light emitting diode, may be applied to a large-size flat panel display.

Further, development of an organic semiconductor layer being capable to have an extended life span at higher current density and thereby at higher brightness is needed. In particular, the development of an organic semiconductor material or semiconductor layer is needed with respect to lowering the operating voltage, which is important for reducing power consumption and increasing battery life, for example of a mobile display device.

It is, therefore, the object of the present invention to provide compounds and semiconducting materials for preparing organic light emitting diodes and display devices overcoming drawbacks of the prior art, in particular with improved performance, especially with longer lifetime and higher voltage stability.

DISCLOSURE

This object is achieved by an organic electronic device comprising a first electrode, a second electrode and an organic semiconducting layer, wherein

- the organic semiconducting layer is arranged between the first electrode and the second electrode; and
- the organic semiconducting layer comprises a compound of formula (I) or (II)

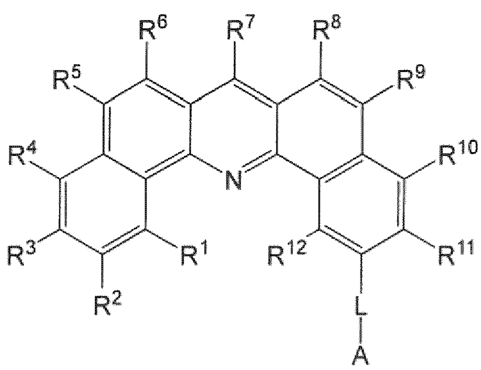

(I)

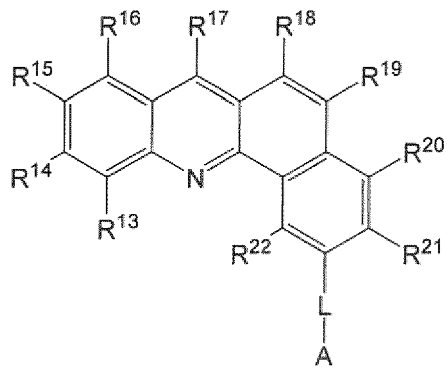

(II)

wherein

- L is a single bond or selected from a substituted or unsubstituted $C_1$ to $C_{36}$ hydrocarbyl and a substituted or unsubstituted $C_2$ to $C_{36}$ heterocyclic group,

- wherein, if L is substituted, the one or more substituent(s) are independently selected from the group consisting of D, substituted or unsubstituted $C_6$ to $C_{12}$ aryl, substituted or unsubstituted $C_3$ to $C_{11}$ heteroaryl, $C_1$ to $C_6$ alkyl, $C_1$ to $C_6$ alkoxy, partially or perfluorinated $C_1$ to $C_6$ alkyl, partially or perfluorinated C. to $C_6$ alkoxy, partially or perdeuterated $C_1$ to $C_6$ alkyl, partially or perdeuterated $C_1$ to $C_6$ alkoxy, halogen, CN or $PY(R^{13})_2$, wherein Y is selected from O, S or Se, preferably O, and $C_3$ to $C_{25}$ silyl, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, and $C_3$ to $C_{25}$ silyl,

- wherein each $C_6$ to $C_{12}$ aryl substituent and each $C_3$ to $C_{11}$ heteroaryl substituent on L may be substituted with one or more independently selected from the group consisting of D, $C_1$ to $C_4$ alkyl, $C_3$ to $C_{25}$ silyl or halogen;

- A is a metal chelating structural moiety;

- $R^1$ to $R^{22}$ are independently selected from the group consisting of H, D, substituted or unsubstituted $C_6$ to $C_{18}$ aryl, substituted or unsubstituted $C_3$ to $C_{17}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated C. to $C_6$ alkoxy,

- wherein the one or more substituents on $C_6$ to $C_{18}$ aryl and $C_3$ to $C_{17}$ heteroaryl, if present, are independently selected from the group consisting of D, $C_1$ to $C_4$ alkyl, $C_3$ to $C_{25}$ silyl or halogen.

This object is further achieved by a display device comprising the organic electronic device, wherein the organic electronic device is an organic light emitting diode.

Furthermore, the object is achieved by a compound of formula (III) or (IV)

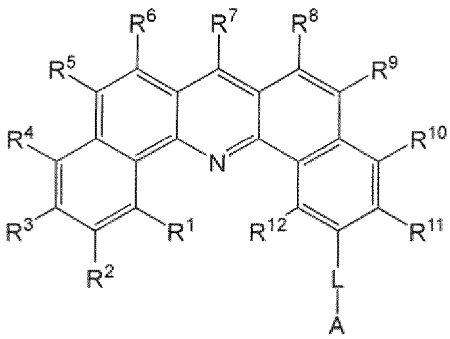
(III)

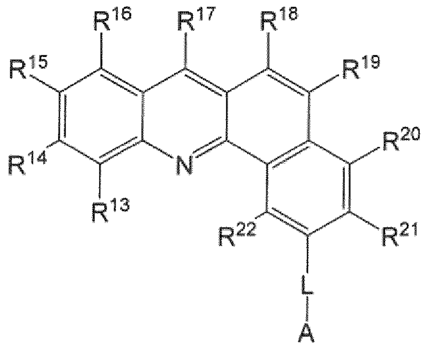
(IV)

wherein

- L is a single bond or selected from a substituted or unsubstituted $C_1$ to $C_{36}$ hydrocarbyl and a substituted or unsubstituted $C_2$ to $C_{36}$ heterocyclic group,

  - wherein, if L is substituted, the one or more substituent(s) are independently selected from the group consisting of D, substituted or unsubstituted $C_6$ to $C_{12}$ aryl, substituted or unsubstituted $C_3$ to $C_{11}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy,

  - wherein each $C_6$ to $C_{12}$ aryl substituent and each $C_3$ to $C_{11}$ heteroaryl substituent on L may be substituted with one or more independently selected from the group consisting of D, $C_1$ to $C_4$ alkyl, $C_3$ to $C_{25}$ silyl or halogen;

- A is a metal chelating structural moiety;

- $R^1$ to $R^{22}$ are independently selected from the group consisting of H, D, substituted or unsubstituted $C_6$ to $C_{18}$ aryl, substituted or unsubstituted $C_3$ to $C_{17}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy,

- wherein the one or more substituents on $C_6$ to $C_{18}$ aryl and $C_3$ to $C_{17}$ heteroaryl, if present, are independently selected from the group consisting of D, $C_1$ to $C_4$ alkyl, $C_3$ to $C_{25}$ silyl or halogen; wherein the following compound is excluded

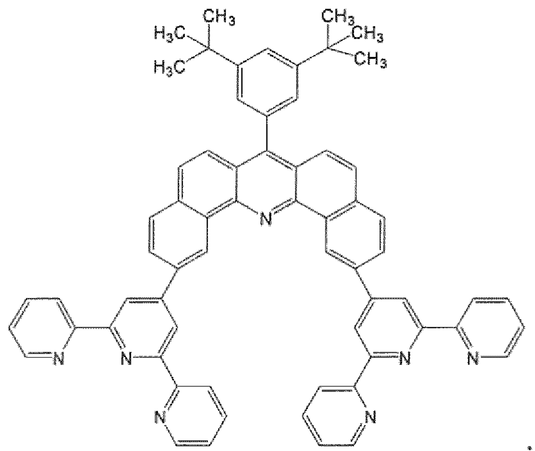

.

Finally, the object is achieved by a compound having formula (V) or (VI)

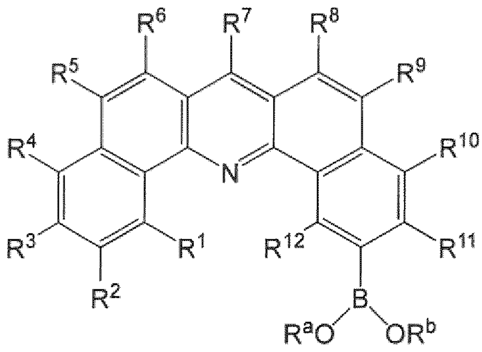

(V)

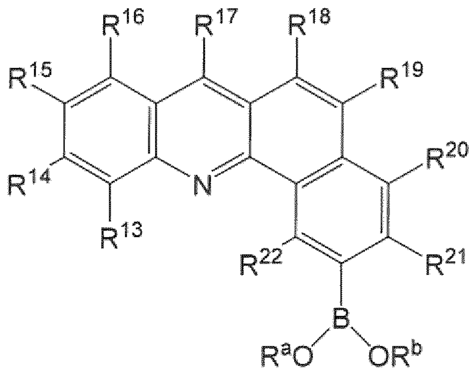

(VI)

wherein

- $R^1$ to $R^{22}$ are independently selected from the group consisting of H, D, substituted or unsubstituted $C_6$ to $C_{18}$ aryl, substituted or unsubstituted $C_3$ to $C_{17}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy,

  - wherein the one or more substituents on $C_6$ to $C_{18}$ aryl and $C_3$ to $C_{17}$ heteroaryl, if present, are independently selected from the group consisting of D, $C_1$ to $C_4$ alkyl, $C_3$ to $C_{25}$ silyl or halogen

- $R^a$ and $R^b$ are independently selected from $C_1$ to $C_{22}$ hydrocarbyl, wherein $R^a$ and $R^b$ can be connected with each other via a single bond.

Compound of formula (I) or (II)

The organic semiconducting layer comprises a compound of formula (I) or (II)

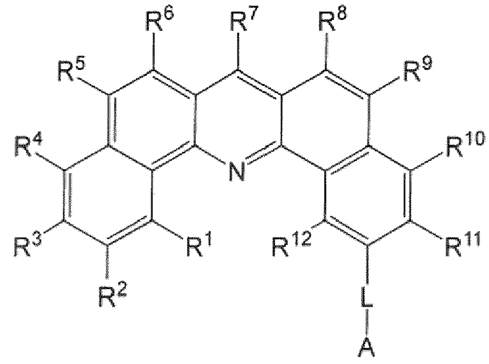
(I)

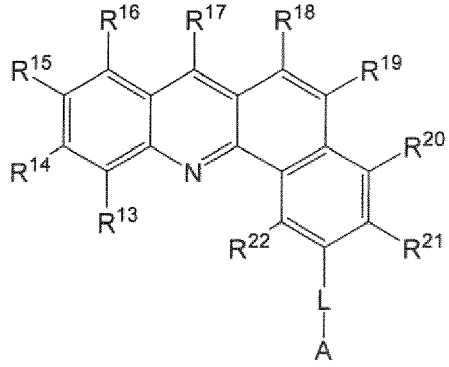
(II)

L is a single bond or is selected from a substituted or unsubstituted $C_1$ to $C_{36}$ hydrocarbyl and a substituted or unsubstituted $C_2$ to $C_{36}$ heterocyclic group. L may be a single bond or is selected from a substituted or unsubstituted $C_1$ to $C_{30}$ hydrocarbyl and a substituted or unsubstituted $C_2$ to $C_{30}$ heterocyclic group. L may be a single bond or may be selected from a substituted or unsubstituted $C_1$ to $C_{24}$ hydrocarbyl and a substituted or unsubstituted $C_2$ to $C_{24}$ heterocyclic group. L may be a single bond or may be selected from a substituted or unsubstituted $C_1$ to $C_{18}$ hydrocarbyl and a substituted or unsubstituted $C_2$ to $C_{18}$ heterocyclic group. L may be a single bond or may be selected from a substituted or unsubstituted C. to $C_{12}$ hydrocarbyl and a substituted or unsubstituted $C_2$ to $C_{12}$ heterocyclic group. L may be a single bond or may be selected from a substituted or unsubstituted $C_1$ to $C_{10}$ hydrocarbyl and a substituted or unsubstituted $C_2$ to $C_{10}$ heterocyclic group. L may be a single bond or may be selected from a substituted or unsubstituted $C_1$ to $C_6$ hydrocarbyl and a substituted or unsubstituted $C_2$ to $C_6$ heterocyclic group.

L may be a single bond or may be selected from a substituted or unsubstituted $C_1$ to $C_{36}$ hydrocarbyl. L may be a single bond or may be selected from a substituted or unsubstituted $C_1$ to $C_{30}$ hydrocarbyl. L may be a single bond or may be selected from a substituted or unsubstituted C. to $C_{24}$ hydrocarbyl. L may be a single bond or may be selected from a substituted or unsubstituted $C_1$ to $C_{18}$ hydrocarbyl. L may be a single bond or may be selected from a substituted or unsubstituted $C_1$ to $C_{12}$ hydrocarbyl. L may be a single bond or may be selected from a substituted or unsubstituted $C_1$ to $C_{10}$ hydrocarbyl. L may be a single bond or may be selected from a substituted or unsubstituted $C_1$ to $C_6$ hydrocarbyl.

L may be a single bond or may be selected from a substituted or unsubstituted $C_6$ to $C_{36}$ aryl. L may be a single bond or may be selected from a substituted or unsubstituted $C_6$ to $C_{30}$ aryl. L may be a single bond or may be selected from a substituted or unsubstituted $C_6$ to $C_{24}$ aryl. L may be a single bond or may be selected from a substituted or unsubstituted $C_6$ to $C_{18}$ aryl. L may be a single bond or may be selected from a substituted or unsubstituted $C_6$ to $C_{12}$ aryl. L may be a single bond or may be selected from a substituted or unsubstituted $C_6$ to $C_{10}$ aryl. L may be a single bond or may be selected substituted or unsubstituted $C_6$ aryl.

If L is substituted, the one or more substituent(s) are independently selected from the group consisting of D, substituted or unsubstituted $C_6$ to $C_{12}$ aryl, substituted or unsubstituted $C_3$ to $C_{11}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{13})_2$, wherein Y is selected from O, S or Se, preferably O, and $C_3$ to $C_{25}$ silyl, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, and $C_3$ to $C_{25}$ silyl,

- wherein each $C_6$ to $C_{12}$ aryl substituent and each $C_3$ to $C_{11}$ heteroaryl substituent on L may be substituted with one or more independently selected from the group consisting of D, $C_1$ to $C_4$ alkyl, $C_3$ to $C_{25}$ silyl or halogen.

If L is substituted, the one or more substituent(s) are independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, and partially or perdeuterated $C_1$ to $C_6$ alkoxy.

If L is substituted, the one or more substituent(s) are independently selected from the group consisting of D, $C_1$ to $C_6$ alkyl, and C. to $C_6$ alkoxy.

If L is substituted, the one or more substituent(s) are independently selected from the group consisting of D, and $C_1$ to $C_6$ alkyl.

If L is substituted, the one or more substituent(s) may be each D.

L may be a single bond or selected from the group consisting of substituted or unsubstituted $C_6$ to $C_{18}$ aryl, wherein, if L is substituted, the one or more substituent(s) are independently selected from the group consisting of D, $C_1$ to $C_6$ alkyl, $C_1$ to $C_6$ alkoxy, partially or perfluorinated C. to $C_6$ alkyl, partially or perfluorinated $C_1$ to $C_6$ alkoxy, partially or perdeuterated $C_1$ to $C_6$ alkyl, and partially or perdeuterated $C_1$ to $C_6$ alkoxy.

L may be a single bond or selected from the group consisting of substituted or unsubstituted $C_6$ to $C_{18}$ aryl, wherein, if L is substituted, the one or more substituent(s) are independently selected from the group consisting of D, $C_1$ to $C_6$ alkyl, and $C_1$ to $C_6$ alkoxy.

L may be a single bond or selected from the group consisting of substituted or unsubstituted $C_6$ to $C_{18}$ aryl, wherein, if L is substituted, the one or more substituent(s) are independently selected from the group consisting of D and $C_1$ to $C_6$ alkyl.

L may be a single bond or selected from the group consisting of substituted or unsubstituted $C_6$ to $C_{18}$ aryl, wherein, if L is substituted, the one or more substituent(s) are each D.

L may be a single bond or selected from the group consisting of substituted or unsubstituted $C_6$ to $C_{12}$ aryl, wherein, if L is substituted, the one or more substituent(s) are independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, and partially or perdeuterated C. to $C_6$ alkoxy.

L may be a single bond or selected from the group consisting of substituted or unsubstituted $C_6$ to $C_{12}$ aryl, wherein, if L is substituted, the one or more substituent(s) are independently selected from the group consisting of D, $C_1$ to $C_6$ alkyl, and $C_1$ to $C_6$ alkoxy.

L may be a single bond or selected from the group consisting of substituted or unsubstituted $C_6$ to $C_{12}$ aryl, wherein, if L is substituted, the one or more substituent(s) are independently selected from the group consisting of D and $C_1$ to $C_6$ alkyl.

L may be a single bond or selected from the group consisting of substituted or unsubstituted $C_6$ to $C_{12}$ aryl, wherein, if L is substituted, the one or more substituent(s) are each D.

L may be a single bond or selected from the group consisting of substituted or unsubstituted phenyl, wherein, if L is substituted, the one or more substituent(s) are independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, and partially or perdeuterated $C_1$ to $C_6$ alkoxy.

L may be a single bond or selected from the group consisting of substituted or unsubstituted phenyl, wherein, if L is substituted, the one or more substituent(s) are independently selected from the group consisting of D, $C_1$ to $C_6$ alkyl, and $C_1$ to $C_6$ alkoxy.

L may be a single bond or selected from the group consisting of substituted or unsubstituted phenyl, wherein, if L is substituted, the one or more substituent(s) are independently selected from the group consisting of D and $C_1$ to $C_6$ alkyl.

L may be a single bond or selected from the group consisting of substituted or unsubstituted phenyl, wherein, if L is substituted, the one or more substituent(s) are each D.

A is a metal chelating structural moiety. In terms of the present disclosure, a metal chelating structural moiety may be a structural moiety which allows formation of a 5-, 6- or 7-membered ring (chelate ring) with a metal atom or a metal cation, wherein the chelate ring comprises two atoms of the metal chelating structural moiety, each of them directly bound to the metal atom or the metal cation by a coordinative bond. The metal or metal cation that may form the 5-, 6- or 7-membered ring (chelate ring) with the metal chelating structural moiety is not particularly limited. Especially in case that the compound of formula (I) or formula (II) forms a matrix for an electrical n-dopant selected from elemental metals or metal salts, the metal or metal cation may be selected from the group consisting of alkali metals, alkaline earth metals and rare earth metals, for example from Li, Na, K, Mg, Ca, Sr, Ba, Yb, Sm and/or Eu.

The metal chelating moiety may comprise 2 to 4 atoms each having a free electron pair. The metal chelating moiety may comprise 2, 3 or 4 atoms each having a free electron pair. The metal chelating moiety may comprise 2 or 3 atoms each having a free electron pair. The metal chelating moiety may comprise 2 atoms each having a free electron pair. The atoms having a free electron pair may be independently selected from the group consisting of O, N, S and P.

The atoms having a free electron pair may be independently selected from the group consisting of 0 and N. The atoms having a free electron pair may be each N.

The metal chelating moiety may be a $C_8$ to $C_{16}$ heteroaryl group comprising 2 to 4 atoms each having a free electron pair. The metal chelating moiety may Ca to $C_{16}$ heteroaryl group comprising 2, 3 or 4 atoms each having a free electron pair. The metal chelating moiety may $C_8$ to $C_{16}$ heteroaryl group comprising 2 or 3 atoms each having a free electron pair. The metal chelating moiety may $C_8$ to $C_{16}$ heteroaryl group comprising 2 atoms each having a free electron pair. The atoms having a free electron pair may be independently selected from the group consisting of O, N, S and P. The atoms having a free electron pair may be independently selected from the group consisting of O and N. The atoms having a free electron pair may be each N.

The metal chelating moiety may be a N-containing $C_8$ to $C_{16}$ heteroaryl group comprising 2 to 4 atoms each having a free electron pair. The metal chelating moiety may N-containing $C_8$ to $C_{16}$ heteroaryl group comprising 2, 3 or 4

atoms each having a free electron pair. The metal chelating moiety may N-containing $C_8$ to $C_{16}$ heteroaryl group comprising 2 or 3 atoms each having a free electron pair. The metal chelating moiety may N-containing Ce to $C_{16}$ heteroaryl group comprising 2 atoms each having a free electron pair.

The metal chelating moiety may be selected from the group consisting of substituted or unsubstituted bipyridyl, substituted or unsubstituted terpyridyl, substituted or unsubstituted phenanthroline, and substituted or unsubstituted 1-(pyridin-2-yl)imidazo[1,5-a]pyridine-3-yl;

wherein the one or more substituent(s), if present, are independently selected from the group consisting of D, $C_6$ to $C_{12}$ aryl, $C_3$ to $C_{11}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, wherein each $C_6$ to $C_{12}$ aryl substituent and each $C_3$ to $C_{11}$ heteroaryl substituent may be substituted with one or more independently selected from the group consisting of D, $C_1$ to $C_4$ alkyl, $C_3$ to $C_{25}$ silyl or halogen.

The metal chelating moiety may be selected from the group consisting of substituted or unsubstituted bipyridyl, substituted or unsubstituted terpyridyl, substituted or unsubstituted phenanthroline, and substituted or unsubstituted 1-(pyridin-2-yl)imidazo[1,5-a]pyridine-3-yl;

wherein the one or more substituent(s), if present, are independently selected from the group consisting of D, $C_1$ to $C_6$ alkyl, $C_1$ to $C_6$ alkoxy, partially or perdeuterated $C_1$ to $C_6$ alkyl, partially or perdeuterated $C_1$ to $C_6$ alkoxy, and $C_3$ to $C_{25}$ silyl.

The metal chelating moiety may be selected from the group consisting of substituted or unsubstituted bipyridyl, and substituted or unsubstituted terpyridyl;

wherein the one or more substituent(s), if present, are independently selected from the group consisting of D, $C_6$ to $C_{12}$ aryl, $C_3$ to $C_{11}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, wherein each $C_6$ to $C_{12}$ aryl substituent and each $C_3$ to $C_{11}$ heteroaryl substituent may be substituted with one or more independently selected from the group consisting of D, $C_1$ to $C_4$ alkyl, $C_3$ to $C_{25}$ silyl or halogen.

The metal chelating moiety may be selected from the group consisting of substituted or unsubstituted bipyridyl, and substituted or unsubstituted terpyridyl;

wherein the one or more substituent(s), if present, are independently selected from the group consisting of D, $C_1$ to $C_6$ alkyl, $C_1$ to $C_6$ alkoxy, partially or perdeuterated $C_1$ to $C_6$ alkyl, partially or perdeuterated $C_1$ to $C_6$ alkoxy, and $C_3$ to $C_{25}$ silyl.

The metal chelating moiety may be substituted or unsubstituted bipyridyl;

wherein the one or more substituent(s), if present, are independently selected from the group consisting of D, $C_6$ to $C_{12}$ aryl, $C_3$ to $C_{11}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, wherein each $C_6$ to $C_{12}$ aryl substituent and each $C_3$ to $C_{11}$ heteroaryl substituent may be substituted with one or more independently selected from the group consisting of D, $C_1$ to $C_4$ alkyl, $C_3$ to $C_{25}$ silyl or halogen.

The metal chelating moiety may be substituted or unsubstituted bipyridyl;

wherein the one or more substituent(s), if present, are independently selected from the group consisting of D, $C_1$ to $C_6$ alkyl, $C_1$ to $C_6$ alkoxy, partially or perdeuterated $C_1$ to $C_6$ alkyl, partially or perdeuterated $C_1$ to $C_6$ alkoxy, and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated C. to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and
- $R^7$ and $R^{17}$ are independently selected from the group consisting of substituted or unsubstituted $C_6$ to $C_{18}$ aryl and substituted or unsubstituted $C_3$ to $C_{17}$ heteroaryl, wherein the one or more substituent(s), if present, are independently selected from the group consisting of D, $C_1$ to $C_4$ alkyl and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and

- $R^7$ and $R^{17}$ are independently selected from the group consisting of substituted or unsubstituted $C_6$ to $C_{12}$ aryl and substituted or unsubstituted $C_3$ to $C_{11}$ heteroaryl, wherein the one or more substituent(s), if present, are independently selected from the group consisting of D, $C_1$ to $C_4$ alkyl and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, C. to $C_6$ alkyl, C. to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and

- $R^7$ and $R^{17}$ are independently selected from the group consisting of substituted or unsubstituted $C_6$ to $C_{10}$ aryl and substituted or unsubstituted $C_3$ to $C_{11}$ heteroaryl, wherein the one or more substituent(s), if present, are independently selected from the group consisting of D, $C_1$ to $C_4$ alkyl and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and
- $R^7$ and $R^{17}$ are independently selected from the group consisting of substituted or unsubstituted $C_6$ to $C_{18}$ aryl, wherein the one or more substituent(s), if present, are independently selected from the group consisting of D, $C_1$ to $C_4$ alkyl and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and

- $R^7$ and $R^{17}$ are independently selected from the group consisting of substituted or unsubstituted $C_6$ to $C_{12}$ aryl, wherein the one or more substituent(s), if present, are independently selected from the group consisting of D, $C_1$ to $C_4$ alkyl and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated C. to $C_6$ alkoxy, partially or perdeuterated C. to $C_6$ alkyl, partially or perdeuterated $C_1$ to $C_6$ alkoxy; and

- $R^7$ and $R^{17}$ are independently selected from the group consisting of substituted or unsubstituted $C_6$ to $C_{10}$ aryl, wherein the one or more substituent(s), if present, are independently selected from the group consisting of D, $C_1$ to $C_4$ alkyl and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perdeuterated $C_1$ to $C_6$ alkyl, partially or perdeuterated $C_1$ to $C_6$ alkoxy, and $C_3$ to $C_{25}$ silyl; and
- $R^7$ and $R^{17}$ are independently selected from the group consisting of substituted or unsubstituted $C_6$ to $C_{18}$ aryl, wherein the one or more substituent(s), if present, are independently selected from the group consisting of D, $C_1$ to $C_4$ alkyl and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perdeuterated $C_1$ to $C_6$ alkyl, partially or perdeuterated $C_1$ to $C_6$ alkoxy, and $C_3$ to $C_{25}$ silyl; and
- $R^7$ and $R^{17}$ are independently selected from the group consisting of substituted or unsubstituted $C_6$ to $C_{12}$ aryl, wherein the one or more substituent(s), if present, are independently selected from the group consisting of D, $C_1$ to $C_4$ alkyl and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perdeuterated $C_1$ to $C_6$ alkyl, partially or perdeuterated $C_1$ to $C_6$ alkoxy, and $C_3$ to $C_{25}$ silyl; and
- $R^7$ and $R^{17}$ are independently selected from the group consisting of substituted or unsubstituted $C_6$ to $C_{10}$ aryl, wherein the one or more substituent(s), if present, are independently selected from the group consisting of D, $C_1$ to $C_4$ alkyl and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, and $C_1$ to $C_6$ alkyl; and
- $R^7$ and $R^{17}$ are independently selected from the group consisting of substituted or unsubstituted $C_6$ to $C_{10}$ aryl, wherein the one or more substituent(s), if present, are independently selected from the group consisting of D, $C_1$ to $C_4$ alkyl and $C_3$ to $C_{25}$ silyl.

According to one embodiment, the organic semiconducting layer comprises a compound of formula (I) as defined above. The organic semiconducting layer may comprises a compound of formula (I) as defined above and may at the same time not comprise a compound of formula (II). In this regard, all embodiments mentioned above in connection with $R^1$ to $R^{12}$, L and A are also embodiments for this embodiment wherein the compound of formula (I) is used.

According to one embodiment, the present invention provides an organic electronic device comprising a first electrode, a second electrode and an organic semiconducting layer, wherein

- the organic semiconducting layer is arranged between the first electrode and the second electrode; and
- the organic semiconducting layer comprises a compound of formula (I) or (II)

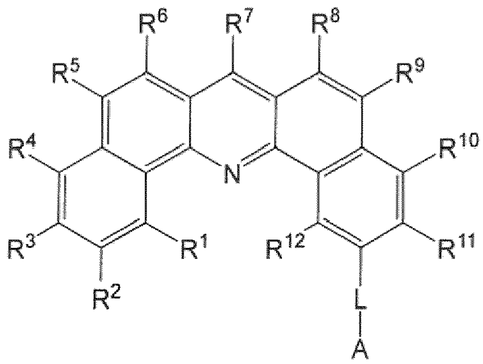

(I)

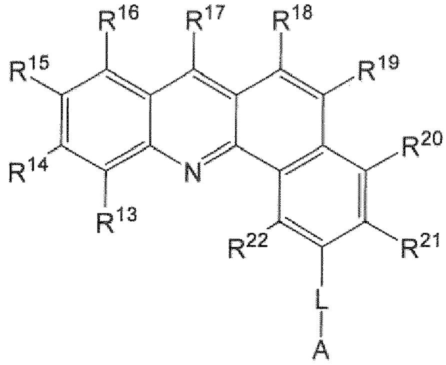

(II)

wherein

- L is a single bond or is selected from a substituted or unsubstituted $C_6$ to $C_{36}$ aryl;
- if L is substituted, the one or more substituent(s) are independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, and partially or perdeuterated $C_1$ to $C_6$ alkoxy;
- A is a metal chelating moiety and the metal chelating moiety is a $C_8$ to $C_{16}$ heteroaryl group comprising 2 to 4 nitrogen (N) atoms each having a free electron pair;
- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and
- $R^7$ and $R^{17}$ are independently selected from the group consisting of substituted or unsubstituted $C_6$ to $C_{12}$ aryl and substituted or unsubstituted $C_3$ to $C_{11}$ heteroaryl, wherein the one or more substituent(s), if present, are independently selected from the group consisting of D, $C_1$ to $C_4$ alkyl and $C_3$ to $C_{25}$ silyl.

According to one embodiment, the present invention provides an organic electronic device comprising a first electrode, a second electrode and an organic semiconducting layer, wherein

- the organic semiconducting layer is arranged between the first electrode and the second electrode; and
- the organic semiconducting layer comprises a compound of formula (I) or (II)

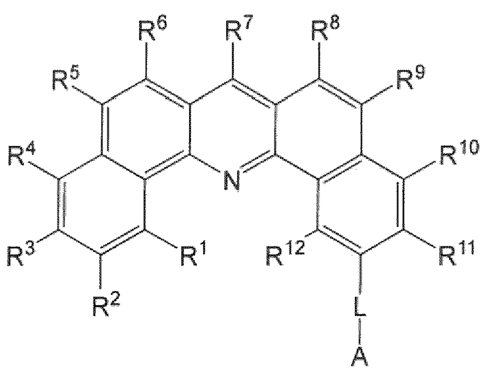

(I)

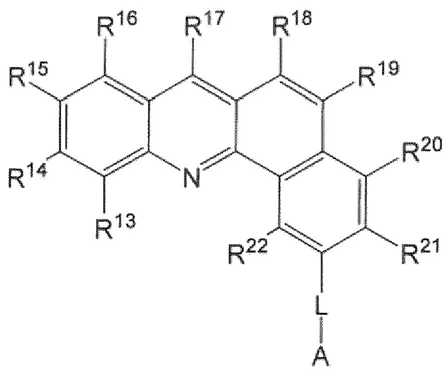

(II)

wherein

- L is a single bond or selected from the group consisting of substituted or unsubstituted $C_6$ to $C_{12}$ aryl, wherein, if L

is substituted, the one or more substituent(s) are independently selected from the group consisting of D, $C_1$ to $C_6$ alkyl, and C, to $C_6$ alkoxy;

- A is a metal chelating moiety and the metal chelating moiety is selected from the group consisting of substituted or unsubstituted bipyridyl, substituted or unsubstituted terpyridyl, substituted or unsubstituted phenanthroline, and substituted or unsubstituted 1-(pyridin-2-yl)imidazo[1,5-a]pyridine-3-yl;

wherein the one or more substituent(s), if present, are independently selected from the group consisting of D, $C_6$ to $C_{12}$ aryl, $C_3$ to $C_{11}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated C. to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, wherein each $C_6$ to $C_{12}$ aryl substituent and each $C_3$ to $C_{11}$ heteroaryl substituent may be substituted with one or more independently selected from the group consisting of D, $C_1$ to $C_4$ alkyl, $C_3$ to $C_{25}$ silyl or halogen;

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perfluorinated $C_1$ to $C_6$ alkyl, partially or perfluorinated C. to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated C. to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and

- $R^7$ and $R^{17}$ are independently selected from the group consisting of substituted or unsubstituted $C_6$ to $C_{18}$ aryl, wherein the one or more substituent(s), if present, are independently selected from the group consisting of D, $C_1$ to $C_4$ alkyl and $C_3$ to $C_{25}$ silyl.

According to one embodiment, the present invention provides an organic electronic device comprising a first electrode, a second electrode and an organic semiconducting layer, wherein

- the organic semiconducting layer is arranged between the first electrode and the second electrode; and

- the organic semiconducting layer comprises a compound of formula (I) or (II)

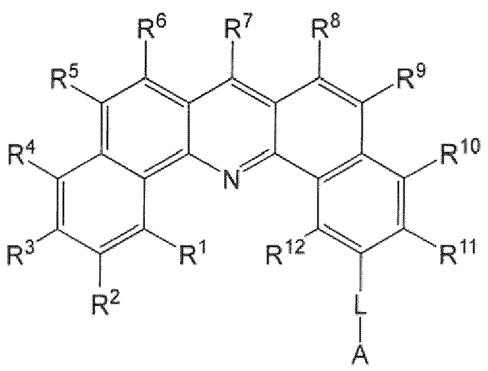
(I)

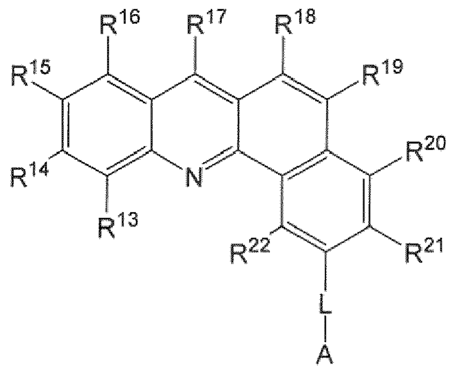
(II)

wherein

- L is a single bond or selected from the group consisting of substituted or unsubstituted $C_6$ to $C_{12}$ aryl, wherein, if L is substituted, the one or more substituent(s) are each D;

- A is a metal chelating moiety and the metal chelating moiety is substituted or unsubstituted bipyridyl;

wherein the one or more substituent(s), if present, are independently selected from the group consisting of D, $C_1$ to $C_6$ alkyl, $C_1$ to $C_6$ alkoxy, partially or perdeuterated $C_1$ to $C_6$ alkyl, partially or perdeuterated $C_1$ to $C_6$ alkoxy, and $C_3$ to $C_{25}$ silyl;

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$

alkoxy, partially or perdeuterated $C_1$ to $C_6$ alkyl, partially or perdeuterated $C_1$ to $C_6$ alkoxy, and $C_3$ to $C_{25}$ silyl; and

- $R^7$ and $R^{17}$ are independently selected from the group consisting of substituted or unsubstituted $C_6$ to $C_{10}$ aryl, wherein the one or more substituent(s), if present, are independently selected from the group consisting of D, $C_1$ to $C_4$ alkyl and $C_3$ to $C_{25}$ silyl.

The compound of formula (I) or (II) may have the formula (I) and may be selected from the following $E_1$ to $E_7$

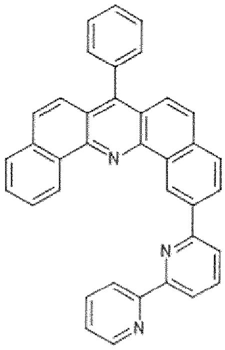
E1

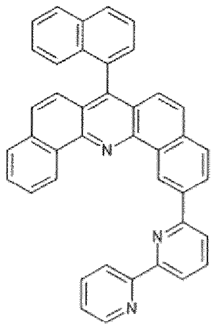
E2

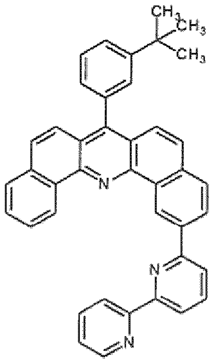
E3

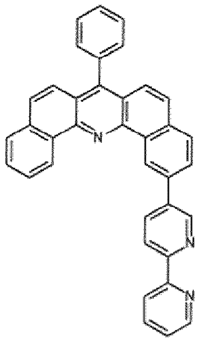
E4

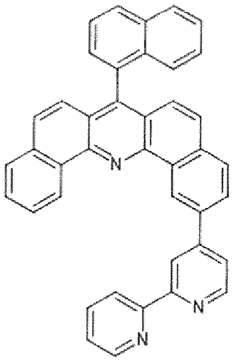
E5

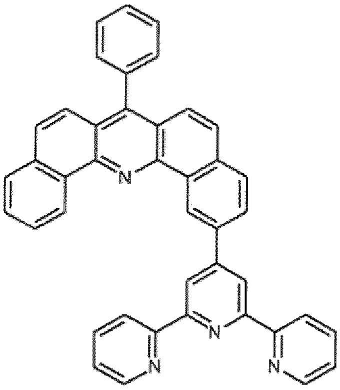
E6

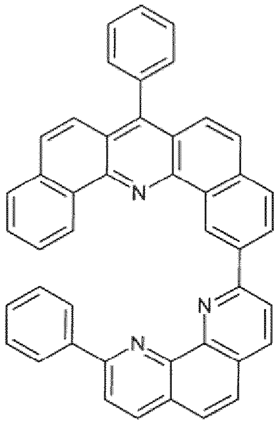
E7.

Organic electronic device

According to one aspect, the invention is related to an organic electronic device. The organic electronic device comprises a first electrode, a second electrode and an organic semiconducting layer. The organic semiconducting layer is arranged between the first electrode and the second electrode. The organic semiconducting layer comprises or consists of compound of formula (I) or (II) according to the present invention, that is, comprises or consists of the compound of formula (I), the compound of formula (II) or a mixture of two or more thereof.

The organic semiconducting layer comprised in the organic electronic device according to the present invention between the first electrode and the second electrode comprises a compound of formula (I) or (II), that is, a compound of formula (I), a compound of formula (II), or a mixture of two or more thereof.

The organic semiconducting layer may comprise the compound of compound of formula (I) or (II) in an amount of at least 50 wt.-% with respect to the total weight of the organic semiconducting layer, or in higher amounts, such as e.g. at least 60 wt.-%, at least 70 wt.-%, at least 80 wt.-%, at least 90 wt.-%, at least 95 wt.-% or at least 98 wt.-% with respect to the total weight of the organic semiconducting layer. The organic semiconducting layer may consist of the compound of compound of formula (I) or (II).

The organic semiconducting material may comprise besides the compound of formula (I) or (II) an electrical dopant, especially an electrical n-dopant.

Under electrical dopant, especially n-type dopant, it is understood a compound which, if embedded into an electron transport matrix, improves, in comparison with the neat matrix under the same physical conditions, the electron properties of the formed organic material, particularly in terms of electron injection and/or electron conductivity.

In the context of the present invention "embedded into an electron transport matrix" means homogenously mixed

with the electron transport matrix.

The electrical dopant as referred to herein is especially selected from elemental metals, metal salts, metal complexes and organic radicals.

In one embodiment, the electrical dopant is selected from alkali metal salts and alkali metal complexes; preferably from lithium salts and lithium organic complexes; more preferably from lithium halides and lithium organic chelates; even more preferably from lithium fluoride, a lithium quinolinolate, lithium borate, lithium phenolate, lithium pyridinolate or from a lithium complex with a Schiff base ligand; most preferably,

- the lithium complex has the formula VII, VIII or IX:

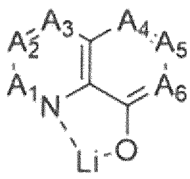 (VII) 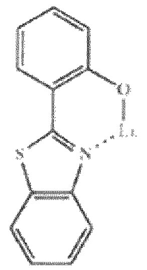 (VIII) 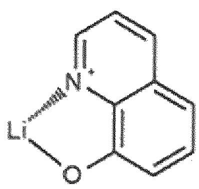 (IX)

wherein

A, to A6 are same or independently selected from CH, CR, N, O;
R is same or independently selected from hydrogen, halogen, alkyl or aryl or heteroaryl with 1 to 20 carbon atoms; and more preferred A, to A6 are CH,

- the borate based organic ligand is a tetra(1H-pyrazol-1-yl)borate,
- the phenolate is a 2-(pyridin-2-yl)phenolate, a 2-(diphenylphosphoryl)phenolate, an imidazol phenolate, 2-(pyridin-2-yl)phenolate or 2-(1-phenyl-1H-benzo[d]imidazol-2-yl)phenolate,
- the pyridinolate is a 2-(diphenylphosphoryl)pyridin-3-olate,
- the lithium Schiff base has the structure 100, 101, 102 or 103:

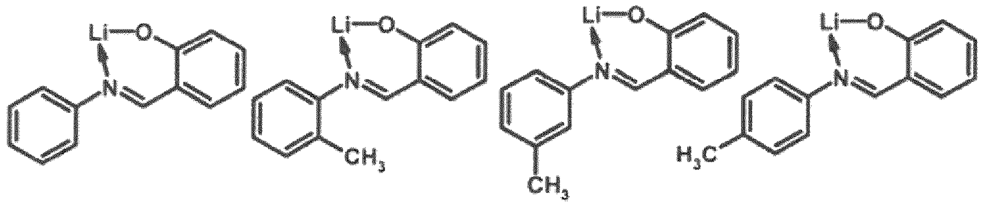

**100** **101** **102** **103**

According to one embodiment of the invention, the electron transport layer of the present invention comprises a lithium organic complex, especially may comprise 8-hydroxyquinolinolato-lithium (= LiQ).

Electrically neutral metal complexes suitable as n-type dopants may be e.g. strongly reductive complexes of some transition metals in low oxidation state. Particularly strong n-type dopants may be selected for example from Cr(II), Mo(II) and/or W(II) guanidinate complexes such as $W_2(hpp)_4$, as described in more detail in WO2005/086251.

Electrically neutral organic radicals suitable as n-type dopants may be e.g. organic radicals created by supply of additional energy from their stable dimers, oligomers or polymers, as described in more detail in EP 1 837 926 B1, WO2007/107306, or WO2007/107356. Under an elemental metal, it is understood a metal in a state of a neat metal, of a metal alloy, or in a state of free atoms or metal clusters. It is understood that metals deposited by vacuum thermal evaporation from a metallic phase, e.g. from a neat bulk metal, vaporize in their elemental form. It is further understood that if the vaporized elemental metal is deposited together with a covalent matrix, the metal atoms and/or clusters are embedded in the covalent matrix. In other words, it is understood that any metal-doped covalent material prepared by vacuum thermal evaporation contains the metal at least partially in its elemental form.

According to one embodiment, the electrical n-Dopant may be an elemental metal, that is, present with the

oxidation number 0 (zero). The metal may be an electropositive metal.

The metal may be selected from the group consisting of alkali metals, alkaline earth metals and rare earth metals. The metal may be selected from the group consisting of Li, Na, K, Mg, Ca, Sr, Ba, Yb, Sm, and Eu. The metal may be selected from the group consisting of Li and Yb. The metal may be Li.

The organic light emitting diode may comprise two or more organic semiconducting layers comprising a semiconducting material in accordance with the invention, respectively.

The organic electronic device may be an organic light emitting diode (OLED). The organic light emitting diode may comprise two or more organic semiconducting layers comprising a semiconducting material in accordance with the invention, respectively. The organic light emitting diode may comprise an anode (e.g. as the first electrode), a cathode (e.g. as the first electrode), a first light emitting layer and the organic semiconducting layer comprising the compound of formula (I) or (II) according to the present invention.

The organic electronic device may be an organic light emitting diode (OLED). The organic light emitting diode may comprise an anode, a cathode, a first emission layer and an organic semiconducting layer,
wherein

- the first emission layer is arranged between the anode and the cathode;
- the organic semiconducting layer is arranged between the first emission layer and the cathode; and
- the semiconducting layer comprises the compound of formula (I) or (II) according to the present invention.

The organic electronic device may be an organic light emitting diode (OLED). The organic light emitting diode may comprise an anode, a cathode, a first emission layer, a second emission layer and an organic semiconducting layer wherein

- the first emission layer is arranged between the anode and the cathode;
- the organic semiconducting layer is arranged between the first light emitting layer and the cathode; and
- the organic semiconducting layer comprises the compound of formula (I) or (II) according to the present invention.

The organic electronic device may be an organic light emitting diode (OLED). The organic light emitting diode may comprise an anode, a cathode, a first emission layer, a second emission layer and an organic semiconducting layer wherein

- the first emission layer and the second emission layer are arranged between the anode and the cathode;
- the organic semiconducting layer is arranged between the first emission layer and the second emission layer; and
- the organic semiconducting layer comprises the compound of formula (I) or (II) according to the present invention.

The organic semiconducting layer may be an electron injection layer, an electron transport layer, a hole blocking layer, or a n-type charge generation layer. The organic semiconducting layer may be an electron injection layer, an electron transport layer, or a n-type charge generation layer. The semiconducting layer may be a n-type charge generation layer.

The organic semiconducting layer may be an n-type charge generation layer, while the OLED may further comprise an electron transport layer and the electron transport layer may be arranged between the first light emitting layer and the n-type charge generation layer.

The organic semiconducting layer may be an n-type charge generation layer, while the OLED may further comprise a hole blocking layer and an electron transport layer and the electron transport layer may be arranged between the hole blocking layer and the n-type charge generation layer.

The organic semiconducting layer may be an n-type charge generation layer, while the OLED may further comprise a hole blocking layer and an electron transport layer and the electron transport layer may be contacting sandwiched between the hole blocking layer and the n-type charge generation layer.

The organic electronic device, especially the organic light emitting diode in accordance with the invention, may comprise further layers in addition to the organic semiconducting layer comprising or consisting of the compound of formula (I) or (II) according to the invention. Exemplary embodiments of respective layers are described in the following:

*Substrate*

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

*Anode electrode*

Either a first electrode or a second electrode comprised in the inventive organic electronic device may be an anode electrode. The anode electrode may be formed by depositing or sputtering a material that is used to form the anode electrode. The material used to form the anode electrode may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide ($SnO_2$), aluminum zinc oxide (AlZO) and zinc oxide (ZnO), may be used to form the anode electrode. The anode electrode may also be formed using metals, typically silver (Ag), gold (Au), or metal alloys.

*Hole injection layer*

A hole injection layer (HIL) may be formed on the anode electrode by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of $10^{-8}$ to $10^{-3}$ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

The HIL may comprise or consist of p-type dopant and the p-type dopant may be selected from tetrafluoro-tetracyanoquinonedimethane (F4TCNQ), 2,2'-(perfluoronaphthalen-2,6-diylidene) dimalononitrile or 2,2',2"-(cyclopropane-1,2,3-triylidene)tris(2-(p-cyanotetrafluorophenyl)acetonitrile) but not limited hereto. The HIL may be selected from a hole-transporting matrix compound doped with a p-type dopant. Typical examples of known doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2 eV) doped with F4TCNQ; $\alpha$-NPD (N,N'-Bis(naphthalen-i-yl)-N,N'-bis(phenyl)-benzidine) doped with F4TCNQ. $\alpha$-NPD doped with 2,2'-(perfluoronaphthalen-2,6-diylidene) dimalononitrile. The p-type dopant concentrations can be selected from 1 to 20 wt.-%, more preferably from $_3$ wt.-% to 10 wt.-%.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

*Hole transport layer*

A hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

*Electron blocking layer*

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

*Photoactive layer (PAL)*

The photoactive layer converts an electrical current into photons or photons into an electrical current.

The PAL may be formed on the HTL by vacuum deposition, spin coating, slot-die coating, printing, casting, LB deposition, or the like. When the PAL is formed using vacuum deposition or spin coating, the conditions for deposition and coating may be similar to those for the formation of the HIL. However, the conditions for deposition and coating may vary, according to the compound that is used to form the PAL.

It may be provided that the photoactive layer does not comprise the compound of formula (I) or (II).

The photoactive layer may be a light-emitting layer or a light-absorbing layer.

*Emission layer (EML)*

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL.

The respective emission layer (EML) may be formed of a combination of a host and an emitter dopant.

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

*Hole blocking layer (HBL)*

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, and phenanthroline derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

The hole blocking layer may be made of the compound of formula (I) or (II) according to the invention, that is, may be the organic semiconducting layer in the organic light emitting diode according to the invention.

*Electron transport layer (ETL)*

The organic electronic device according to the present invention may comprise an electron transport layer (ETL).

According to various embodiments the OLED may comprise an electron transport layer or an electron transport layer stack comprising at least a first electron transport layer and at least a second electron transport layer.

By suitably adjusting energy levels of particular layers of the ETL, the injection and transport of the electrons may be controlled, and the holes may be efficiently blocked. Thus, the OLED may have long lifetime.

The electron transport layer may comprise electron transport materials (ETM) comprising one or more electron transport compound(s) known in the art.

Suitable compounds for the ETM (which may be used in addition to the inventive compound as defined above) are not particularly limited. In one embodiment, the electron transport matrix compounds consist of covalently bound atoms. Preferably, the electron transport matrix compound comprises a conjugated system of at least 6, more preferably of at least 10 delocalized electrons. In one embodiment, the conjugated system of delocalized electrons may be comprised in aromatic or heteroaromatic structural moieties, as disclosed e.g. in documents EP 1 970 371 A1 or WO 2013/079217 A1.Further, the electron transport layer may comprise one or more additives. The additive may be an n-type dopant. The additive can be alkali metal, alkali metal compound, alkaline earth metal, alkaline earth metal compound, transition metal, transition metal compound or a rare earth metal. In another embodiment, the metal can be one selected from a group consisting of Li, Na, K, Rb, Cs, Mg, Ca, Sr, Ba, La, Ce, Sm, Eu, Tb, Dy, and Yb. In another embodiment, the n-type dopant can be one selected from a group consisting of Cs, K, Rb, Mg, Na, Ca, Sr, Eu and Yb. In an embodiment the alkali metal compound may be 8-Hydroxyquinolinolato-lithium (LiQ), Lithium tetra(1H-pyrazol-1-yl)borate or Lithium 2-(diphenylphosphoryl)phenolate.

The electron transport layer may have a thickness from about 1 to about 100 nm, such as from about 10 to about 50 nm.

The electron transport layer may comprise or consist of the compound of formula (I) or (II) according to the invention, that is, may be the organic semiconducting layer in the organic electronic device according to the invention.

*Electron injection layer (EIL)*

The optional EIL, which may facilitate injection of electrons from the cathode, may be formed on the ETL, preferably directly on the electron transport layer. Examples of materials for forming the EIL include lithium 8-hydroxyquinolinolate (LiQ), LiF, NaCl, CsF, $Li_2O$, BaO, Ca, Ba, Yb, Mg, especially Yb which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

The electron injection layer may comprise the compound of formula (I) or (II) according to the invention, that is, may be the organic semiconducting layer in the organic electronic device according to the invention.

*Cathode electrode*

The cathode electrode is formed on the EIL if present. The cathode electrode may be formed of a metal, an alloy, an electrically conductive compound, or a mixture thereof. The cathode electrode may have a low work function. For example, the cathode electrode may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO. The cathode may comprise more that 50 volume 96 of metal selected from Ag and Au.

The thickness of the cathode electrode may be in the range from about 5 nm to about 1000 nm, for example, in the range from about 10 nm to about 100 nm. When the thickness of the cathode electrode is in the range from about 5 nm to about 50 nm, the cathode electrode may be transparent or semitransparent even if formed from a metal or metal alloy.

The cathode may be a semi-transparent metal cathode having a thickness less than 20 nm, preferably less than 15 nm.

It is to be understood that the cathode electrode is not part of an electron injection layer or the electron transport layer.

*Charge generation layer/hole generation layer*

The organic electronic device according to the present invention may comprise a charge generation layer. The charge generation layer (CGL) is composed of a double layer.

The charge generation layer is a pn junction joining an n-type charge generation layer (electron generation layer) and a p-type charge generation layer (hole generation layer). The n-side of the pn junction generates electrons and injects them into the layer which is adjacent in the direction to the anode. Analogously, the p-side of the p-n junction generates holes and injects them into the layer which is adjacent in the direction to the cathode.

Charge generation layers are used in tandem devices, for example, in tandem OLEDs comprising, between two electrodes, two or more emission layers. In a tandem OLED comprising two emission layers, the n-type charge generation layer provides electrons for the first light emission layer arranged near the anode, while the p-type charge generation layer provides holes to the second light emission layer arranged between the first emission layer and the cathode.

The hole generation layer (p-type charge generation layer) can be composed of an organic matrix material doped with p-type dopant. Suitable matrix materials for the hole generation layer may be materials conventionally used as hole injection and/or hole transport matrix materials. Also, p-type dopant used for the hole generation layer can employ conventional materials. For example, the p-type dopant can be one selected from a group consisting of tetrafluore-7,7,8,8-tetracyanoquinodimethane (F4-TCNQ), derivatives of tetracyanoquinodimethane, radialene derivatives, iodine, $FeCl_3$, $FeF_3$, and $SbCl_5$. Also, the host can be one selected from a group consisting of N,N'-di(naphthalen-1-yl)-N,N-diphenyl-benzidine (NPB), N,N'-diphenyl-N,N'-bis(3-methylphenyl)-1,1-biphenyl-4,4'-diamine (TPD) and N,N',N'-tetranaphthyl-benzidine (TNB).

The n-type charge generation layer can be layer of a neat n-dopant, for example of an electropositive metal, or can consist of an organic matrix material doped with the n-dopant. In one embodiment, the n-type dopant can be alkali metal, alkali metal compound, alkaline earth metal, or alkaline earth metal compound. In another embodiment, the metal can be one selected from a group consisting of Li, Na, K, Rb, Cs, Mg, Ca, Sr, Ba, La, Ce, Sm, Eu, Tb, Dy, and Yb. More specifically, the n-type dopant can be one selected from a group consisting of Cs, K, Rb, Mg, Na, Ca, Sr, Eu and Yb. Suitable matrix materials for the electron generating layer may be the materials conventionally used as matrix materials for electron injection or electron transport layers. The matrix material can be for example one selected from a group consisting of triazine compounds, hydroxyquinoline derivatives like tris(8-hydroxyquinoline)aluminum, benzazole derivatives, and silole derivatives.

The n-type charge generation layer may comprise the compound of formula (I) or (II) according to the invention, that is, may be the organic semiconducting layer in the organic light emitting diode according to the invention.

According to one aspect, the OLED according to the present invention can comprise a layer structure of a substrate that is adjacent arranged to an anode electrode, the anode electrode is adjacent arranged to a first hole injection layer, the first hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to an electron blocking layer, the electron blocking layer is adjacent arranged to an electron transport layer, the electron transport layer is adjacent arranged to an electron injection layer, the electron injection layer is adjacent arranged to a cathode, wherein the electron transport layer is the organic semiconducting layer according to the present invention.

According to one aspect, the OLED according to the present invention can comprise a layer structure of a substrate that is adjacent arranged to an anode electrode, the anode electrode is adjacent arranged to a first hole injection layer, the first hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to a first electron transport layer, the first electron transport layer is adjacent arranged to an n-type charge generation layer (n-type sub-layer), the n-type charge generation layer is adjacent arranged to a hole generating layer (p-type sub-layer), an interlayer may be provided between the n-type sub-layer, and the p-type sub-layer, the hole generating layer is adjacent arranged to a second hole transport layer, the second hole transport layer is adjacent arranged to a second electron blocking layer, the second electron blocking layer is adjacent arranged to a second emission layer, between the second emission layer and the cathode electrode an electron transport layer and/or an electron injection layer are arranged, wherein n-type charge generation layer is the organic semiconducting layer according to the present invention.

Display device

According to a further aspect, the invention is related to a display device comprising the organic light emitting

diode according to the invention.

The display device may be a television, a tablet, or a mobile phone.

Process for preparing the organic light emitting diode

According to a further aspect, the invention is related to a process for preparing the organic electronic device according to the present invention, wherein the process comprises a step of depositing compound of formula (I) or (II) according to the present invention on a solid support.

The method for depositing may comprise:

- deposition via vacuum thermal evaporation;
- deposition via solution processing, preferably the processing is selected from spin-coating, printing, casting; and/or
- slot-die coating.

Compound of formula (III) or (IV)

According to a further aspect, the present invention relates to a compound of formula (III) or (IV)

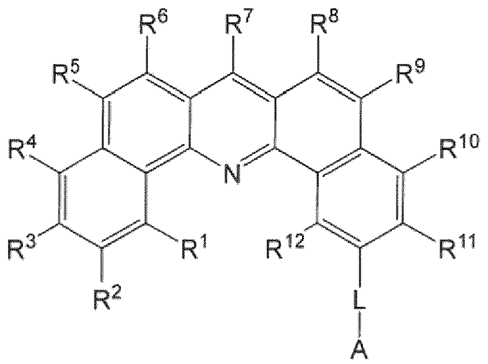
(III)

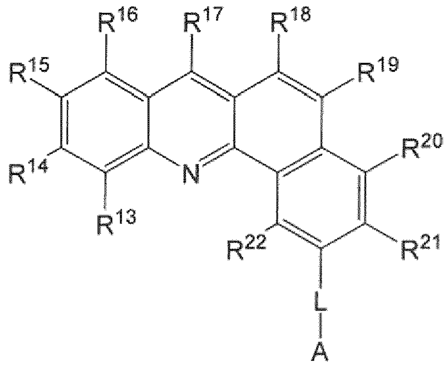
(IV)

wherein the following compound

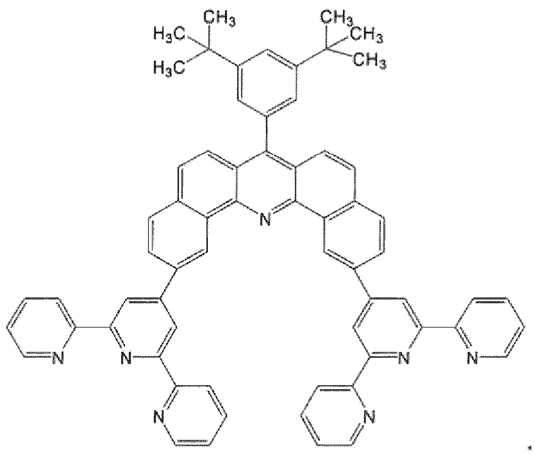

having the CAS number 343313-85-9 is excluded from all embodiments of the compound of formula (III) or (IV) otherwise comprising said compound.

All embodiments described above for the compounds of formulas (I) and (II) are also embodiments for the compounds of formulas (III) and (IV) provided that the compound CAS number 343313-85-9 is excluded from the respective embodiments.

L is a single bond or is selected from a substituted or unsubstituted $C_1$ to $C_{36}$ hydrocarbyl and a substituted or unsubstituted $C_2$ to $C_{36}$ heterocyclic group. L may be a single bond or is selected from a substituted or unsubstituted $C_1$ to

$C_{30}$ hydrocarbyl and a substituted or unsubstituted $C_2$ to $C_{30}$ heterocyclic group. L may be a single bond or may be selected from a substituted or unsubstituted $C_1$ to $C_{24}$ hydrocarbyl and a substituted or unsubstituted $C_2$ to $C_{24}$ heterocyclic group. L may be a single bond or may be selected from a substituted or unsubstituted $C_1$ to $C_{18}$ hydrocarbyl and a substituted or unsubstituted $C_2$ to $C_{18}$ heterocyclic group. L may be a single bond or may be selected from a substituted or unsubstituted $C_1$ to $C_{12}$ hydrocarbyl and a substituted or unsubstituted $C_2$ to $C_{12}$ heterocyclic group. L may be a single bond or may be selected from a substituted or unsubstituted $C_1$ to $C_{10}$ hydrocarbyl and a substituted or unsubstituted $C_2$ to $C_{10}$ heterocyclic group. L may be a single bond or may be selected from a substituted or unsubstituted $C_1$ to $C_6$ hydrocarbyl and a substituted or unsubstituted $C_2$ to $C_6$ heterocyclic group.

L may be a single bond or may be selected from a substituted or unsubstituted $C_1$ to $C_{36}$ hydrocarbyl. L may be a single bond or may be selected from a substituted or unsubstituted $C_1$ to $C_{30}$ hydrocarbyl. L may be a single bond or may be selected from a substituted or unsubstituted $C_1$ to $C_{24}$ hydrocarbyl. L may be a single bond or may be selected from a substituted or unsubstituted $C_1$ to $C_{18}$ hydrocarbyl. L may be a single bond or may be selected from a substituted or unsubstituted $C_1$ to $C_{12}$ hydrocarbyl. L may be a single bond or may be selected from a substituted or unsubstituted $C_1$ to $C_{10}$ hydrocarbyl. L may be a single bond or may be selected from a substituted or unsubstituted $C_1$ to $C_6$ hydrocarbyl.

L may be a single bond or may be selected from a substituted or unsubstituted $C_6$ to $C_{36}$ aryl. L may be a single bond or may be selected from a substituted or unsubstituted $C_6$ to $C_{30}$ aryl. L may be a single bond or may be selected from a substituted or unsubstituted $C_6$ to $C_{24}$ aryl. L may be a single bond or may be selected from a substituted or unsubstituted $C_6$ to $C_{18}$ aryl. L may be a single bond or may be selected from a substituted or unsubstituted $C_6$ to $C_{12}$ aryl. L may be a single bond or may be selected from a substituted or unsubstituted $C_6$ to $C_{10}$ aryl. L may be a single bond or may be selected substituted or unsubstituted $C_6$ aryl.

If L is substituted, the one or more substituent(s) are independently selected from the group consisting of D, substituted or unsubstituted $C_6$ to $C_{12}$ aryl, substituted or unsubstituted $C_3$ to $C_{11}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{13})_2$, wherein Y is selected from O, S or Se, preferably O, and $C_3$ to $C_{25}$ silyl, and R'3 is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, and $C_3$ to $C_{25}$ silyl,

- wherein each $C_6$ to $C_{12}$ aryl substituent and each $C_3$ to $C_{11}$ heteroaryl substituent on L may be substituted with one or more independently selected from the group consisting of D, $C_1$ to $C_4$ alkyl, $C_3$ to $C_{25}$ silyl or halogen.

If L is substituted, the one or more substituent(s) are independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, and partially or perdeuterated $C_1$ to $C_6$ alkoxy.

If L is substituted, the one or more substituent(s) are independently selected from the group consisting of D, $C_1$ to $C_6$ alkyl, and $C_1$ to $C_6$ alkoxy.

If L is substituted, the one or more substituent(s) are independently selected from the group consisting of $D_1$ and $C_1$ to $C_6$ alkyl.

If L is substituted, the one or more substituent(s) may be each D.

L may be a single bond or selected from the group consisting of substituted or unsubstituted $C_6$ to $C_{18}$ aryl, wherein, if L is substituted, the one or more substituent(s) are independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, and partially or perdeuterated $C_1$ to $C_6$ alkoxy.

L may be a single bond or selected from the group consisting of substituted or unsubstituted $C_6$ to $C_{18}$ aryl, wherein, if L is substituted, the one or more substituent(s) are independently selected from the group consisting of D, $C_1$ to $C_6$ alkyl, and $C_1$ to $C_6$ alkoxy.

L may be a single bond or selected from the group consisting of substituted or unsubstituted $C_6$ to $C_{18}$ aryl, wherein, if L is substituted, the one or more substituent(s) are independently selected from the group consisting of D and $C_1$ to $C_6$ alkyl.

L may be a single bond or selected from the group consisting of substituted or unsubstituted $C_6$ to $C_{18}$ aryl, wherein, if L is substituted, the one or more substituent(s) are each D.

L may be a single bond or selected from the group consisting of substituted or unsubstituted $C_6$ to $C_{12}$ aryl, wherein, if L is substituted, the one or more substituent(s) are independently selected from the group consisting of D, C. to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, and partially or perdeuterated $C_1$ to $C_6$ alkoxy.

L may be a single bond or selected from the group consisting of substituted or unsubstituted $C_6$ to $C_{12}$ aryl, wherein, if L is substituted, the one or more substituent(s) are independently selected from the group consisting of D, $C_1$ to $C_6$ alkyl, and $C_1$ to $C_6$ alkoxy.

L may be a single bond or selected from the group consisting of substituted or unsubstituted $C_6$ to $C_{12}$ aryl, wherein, if L is substituted, the one or more substituent(s) are independently selected from the group consisting of D and $C_1$ to $C_6$ alkyl.

L may be a single bond or selected from the group consisting of substituted or unsubstituted $C_6$ to $C_{12}$ aryl, wherein, if L is substituted, the one or more substituent(s) are each D.

L may be a single bond or selected from the group consisting of substituted or unsubstituted phenyl, wherein, if L is substituted, the one or more substituent(s) are independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, and partially or perdeuterated $C_1$ to $C_6$ alkoxy.

L may be a single bond or selected from the group consisting of substituted or unsubstituted phenyl, wherein, if L is substituted, the one or more substituent(s) are independently selected from the group consisting of D, $C_1$ to $C_6$ alkyl, and $C_1$ to $C_6$ alkoxy.

L may be a single bond or selected from the group consisting of substituted or unsubstituted phenyl, wherein, if L is substituted, the one or more substituent(s) are independently selected from the group consisting of D and $C_1$ to $C_6$ alkyl.

L may be a single bond or selected from the group consisting of substituted or unsubstituted phenyl, wherein, if L is substituted, the one or more substituent(s) are each D.

A is a metal chelating structural moiety. In terms of the present disclosure, a metal chelating structural moiety may be a structural moiety which allows formation of a 5-, 6- or 7-membered ring (chelate ring) with a metal atom or a metal cation, wherein the chelate ring comprises two atoms of the metal chelating structural moiety, each of them directly bound to the metal atom or the metal cation by a coordinative bond. The metal or metal cation that may form the chelate ring is not particularly limited but may be selected from the group consisting of alkali metals, alkaline earth metals and rare earth metals, for example from Li, Na, K, Mg, Ca, Sr, Ba, Yb, Sm and/or Eu.

The metal chelating moiety may comprise 2 to 4 atoms each having a free electron pair. The metal chelating moiety may comprise 2, 3 or 4 atoms each having a free electron pair. The metal chelating moiety may comprise 2 or 3 atoms each having a free electron pair. The metal chelating moiety may comprise 2 atoms each having a free electron pair. The atoms having a free electron pair may be independently selected from the group consisting of O, N, S and P. The atoms having a free electron pair may be independently selected from the group consisting of O and N. The atoms having a free electron pair may be each N.

The metal chelating moiety may be a $C_8$ to $C_{16}$ heteroaryl group comprising 2 to 4 atoms each having a free electron pair. The metal chelating moiety may $C_8$ to $C_{16}$ heteroaryl group comprising 2, 3 or 4 atoms each having a free electron pair. The metal chelating moiety may $C_8$ to $C_{16}$ heteroaryl group comprising 2 or 3 atoms each having a free electron pair. The metal chelating moiety may $C_8$ to $C_{16}$ heteroaryl group comprising 2 atoms each having a free electron pair. The atoms having a free electron pair may be independently selected from the group consisting of O, N, S and P. The atoms having a free electron pair may be independently selected from the group consisting of O and N. The atoms having a free electron pair may be each N.

The metal chelating moiety may be a N-containing $C_8$ to $C_{16}$ heteroaryl group comprising 2 to 4 atoms each having a free electron pair. The metal chelating moiety may N-containing $C_8$ to $C_{16}$ heteroaryl group comprising 2, 3 or 4 atoms each having a free electron pair. The metal chelating moiety may N-containing $C_8$ to $C_{16}$ heteroaryl group comprising 2 or 3 atoms each having a free electron pair. The metal chelating moiety may N-containing $C_8$ to $C_{16}$ heteroaryl group comprising 2 atoms each having a free electron pair.

The metal chelating moiety may be selected from the group consisting of substituted or unsubstituted bipyridyl, substituted or unsubstituted terpyridyl, substituted or unsubstituted phenanthroline, and substituted or unsubstituted 1-(pyridin-2-yl)imidazo[1,5-a]pyridine-3-yl;

wherein the one or more substituent(s), if present, are independently selected from the group consisting of D, $C_6$ to $C_{12}$ aryl, $C_3$ to $C_{11}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, wherein each $C_6$ to $C_{12}$ aryl substituent and each $C_3$ to $C_{11}$ heteroaryl substituent may be substituted with one or more independently selected from the group consisting of D, $C_1$ to $C_4$ alkyl, $C_3$ to $C_{25}$ silyl or halogen.

The metal chelating moiety may be selected from the group consisting of substituted or unsubstituted bipyridyl, substituted or unsubstituted terpyridyl, substituted or unsubstituted phenanthroline, and substituted or unsubstituted 1-(pyridin-2-yl)imidazo[1,5-a]pyridine-3-yl;

wherein the one or more substituent(s), if present, are independently selected from the group consisting of D, $C_1$ to $C_6$ alkyl, $C_1$ to $C_6$ alkoxy, partially or perdeuterated $C_1$ to $C_6$ alkyl, partially or perdeuterated $C_1$ to $C_6$ alkoxy, and $C_3$ to $C_{25}$ silyl.

The metal chelating moiety may be selected from the group consisting of substituted or unsubstituted bipyridyl, and substituted or unsubstituted terpyridyl;

wherein the one or more substituent(s), if present, are independently selected from the group consisting of D, $C_6$ to $C_{12}$ aryl, $C_3$ to $C_{11}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, wherein each $C_6$ to $C_{12}$ aryl substituent and each $C_3$ to $C_{11}$ heteroaryl substituent may be substituted with one or more independently selected from the group consisting of D, $C_1$ to $C_4$ alkyl, $C_3$ to $C_{25}$ silyl or halogen.

The metal chelating moiety may be selected from the group consisting of substituted or unsubstituted bipyridyl, and substituted or unsubstituted terpyridyl;
wherein the one or more substituent(s), if present, are independently selected from the group consisting of D, $C_1$ to $C_6$ alkyl, $C_1$ to $C_6$ alkoxy, partially or perdeuterated $C_1$ to $C_6$ alkyl, partially or perdeuterated $C_1$ to $C_6$ alkoxy, and $C_3$ to $C_{25}$ silyl.

The metal chelating moiety may be substituted or unsubstituted bipyridyl;
wherein the one or more substituent(s), if present, are independently selected from the group consisting of D, $C_6$ to $C_{12}$ aryl, $C_3$ to $C_{11}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, wherein each $C_6$ to $C_{12}$ aryl substituent and each $C_3$ to $C_{11}$ heteroaryl substituent may be substituted with one or more independently selected from the group consisting of D, $C_1$ to $C_4$ alkyl, $C_3$ to $C_{35}$ silyl or halogen.

The metal chelating moiety may be substituted or unsubstituted bipyridyl;
wherein the one or more substituent(s), if present, are independently selected from the group consisting of D, $C_1$ to $C_6$ alkyl, $C_1$ to $C_6$ alkoxy, partially or perdeuterated $C_1$ to $C_6$ alkyl, partially or perdeuterated $C_1$ to $C_6$ alkoxy, and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and
- $R^7$ and $R^{17}$ are independently selected from the group consisting of substituted or unsubstituted $C_6$ to $C_{18}$ aryl and substituted or unsubstituted $C_3$ to $C_{17}$ heteroaryl, wherein the one or more substituent(s), if present, are independently selected from the group consisting of D, $C_1$ to $C_4$ alkyl and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and

- $R^7$ and $R^{17}$ are independently selected from the group consisting of substituted or unsubstituted $C_6$ to $C_{12}$ aryl and substituted or unsubstituted $C_3$ to $C_{11}$ heteroaryl, wherein the one or more substituent(s), if present, are independently selected from the group consisting of D, $C_1$ to $C_4$ alkyl and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and

- $R^7$ and $R^{17}$ are independently selected from the group consisting of substituted or unsubstituted $C_6$ to $C_{10}$ aryl and substituted or unsubstituted $C_3$ to $C_{11}$ heteroaryl, wherein the one or more substituent(s), if present, are independently selected from the group consisting of D, $C_1$ to $C_4$ alkyl and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated C. to $C_6$ alkyl, partially or perdeuterated $C_1$ to $C_6$ alkoxy, halogen, $C_3$ to $C_{25}$ silyl, CN or $PY(R^{13})_2$, wherein Y is selected from 4, S or Se, preferably O, and $R^{13}$ is independently selected from $C_6$ to $C_{12}$ aryl, $C_3$ to $C_{12}$ heteroaryl, $C_1$ to $C_6$ alkyl, C. to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and
- $R^7$ and $R^{17}$ are independently selected from the group consisting of substituted or unsubstituted $C_6$ to $C_{18}$ aryl, wherein the one or more substituent(s), if present, are independently selected from the group consisting of D, $C_1$ to $C_4$ alkyl and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and

- $R^7$ and $R^{17}$ are independently selected from the group consisting of substituted or unsubstituted $C_6$ to $C_{12}$ aryl, wherein the one or more substituent(s), if present, are independently selected from the group consisting of D, $C_1$ to $C_4$ alkyl and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13}{}_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and

- $R^7$ and $R^{17}$ are independently selected from the group consisting of substituted or unsubstituted $C_6$ to $C_{10}$ aryl, wherein the one or more substituent(s), if present, are independently selected from the group consisting of D, $C_1$ to $C_4$ alkyl and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, $C_1$ to $C_6$ alkyl, C. to $C_6$ alkoxy, partially or perdeuterated $C_1$ to $C_6$ alkyl, partially or perdeuterated $C_1$ to $C_6$ alkoxy, and $C_3$ to $C_{25}$ silyl; and

- $R^7$ and $R^{17}$ are independently selected from the group consisting of substituted or unsubstituted $C_6$ to $C_{18}$ aryl, wherein the one or more substituent(s), if present, are independently selected from the group consisting of D, $C_1$ to $C_4$ alkyl and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perdeuterated $C_1$ to $C_6$ alkyl, partially or perdeuterated $C_1$ to $C_6$ alkoxy, and $C_3$ to $C_{25}$ silyl; and

- R7 and $R^{17}$ are independently selected from the group consisting of substituted or unsubstituted $C_6$ to $C_{12}$ aryl, wherein the one or more substituent(s), if present, are independently selected from the group consisting of D, $C_1$ to $C_4$

alkyl and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, C, to $C_6$ alkyl, $C_1$ to $C_6$ alkoxy, partially or perdeuterated $C_1$ to $C_6$ alkyl, partially or perdeuterated $C_1$ to $C_6$ alkoxy, and $C_3$ to $C_{25}$ silyl; and
- $R^7$ and $R^{17}$ are independently selected from the group consisting of substituted or unsubstituted $C_6$ to $C_{10}$ aryl, wherein the one or more substituent(s), if present, are independently selected from the group consisting of D, $C_1$ to $C_4$ alkyl and $C_3$ to $C_{25}$ silyl.

According to one embodiment,

- $R^1$ to $R^6$, $R^8$ to $R^{16}$ and $R^{18}$ to $R^{22}$ are independently selected from the group consisting of H, D, and $C_1$ to $C_6$ alkyl; and
- $R^7$ and $R^{17}$ are independently selected from the group consisting of substituted or unsubstituted $C_6$ to $C_{10}$ aryl, wherein the one or more substituent(s), if present, are independently selected from the group consisting of D, $C_1$ to $C_4$ alkyl and $C_3$ to $C_{25}$ silyl.

According to one embodiment, the organic semiconducting layer comprises a compound of formula (III) as defined above. The organic semiconducting layer may comprises a compound of formula (III) as defined above and may at the same time not comprise a compound of formula (IV). In this regard, all embodiments mentioned above in connection with $R^1$ to $R^{12}$, L and A are also embodiments for this embodiment wherein the compound of formula (III) is used.

According to one embodiment, the present invention provides an organic electronic device comprising a first electrode, a second electrode and an organic semiconducting layer, wherein

- the organic semiconducting layer is arranged between the first electrode and the second electrode; and
- the organic semiconducting layer comprises a compound of formula (III) or (IV)

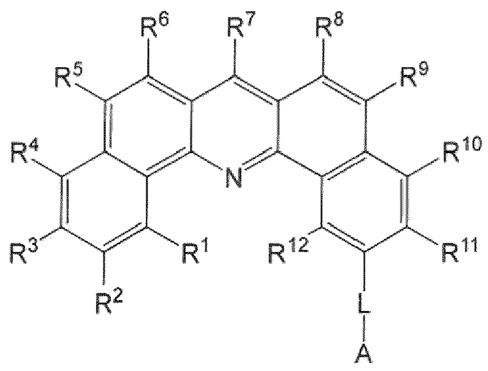
(III)

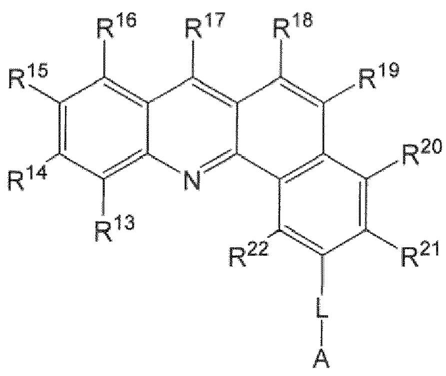
(IV)

wherein

- L is a single bond or is selected from a substituted or unsubstituted $C_6$ to $C_{36}$ aryl;
- if L is substituted, the one or more substituent(s) are independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, and partially or perdeuterated $C_1$ to $C_6$ alkoxy;
- A is a metal chelating moiety and the metal chelating moiety is a $C_8$ to $C_{16}$ heteroaryl group comprising 2 to 4 nitrogen (N) atoms each having a free electron pair;
- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to

$C_{12}$ heteroaryl, C, to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and

- $R^7$ and $R^{17}$ are independently selected from the group consisting of substituted or unsubstituted $C_6$ to $C_{12}$ aryl and substituted or unsubstituted $C_3$ to $C_{11}$ heteroaryl, wherein the one or more substituent(s), if present, are independently selected from the group consisting of D, $C_1$ to $C_4$ alkyl and $C_3$ to $C_{25}$ silyl.

According to one embodiment, the present invention provides an organic electronic device comprising a first electrode, a second electrode and an organic semiconducting layer, wherein

- the organic semiconducting layer is arranged between the first electrode and the second electrode; and
- the organic semiconducting layer comprises a compound of formula (III) or (IV)

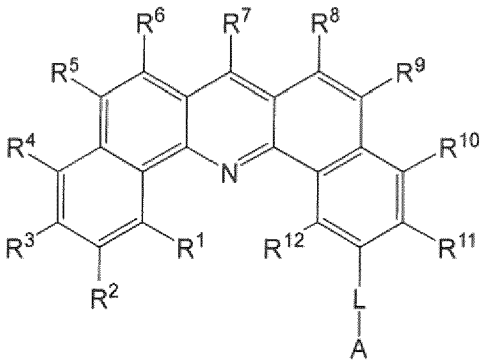

(III)

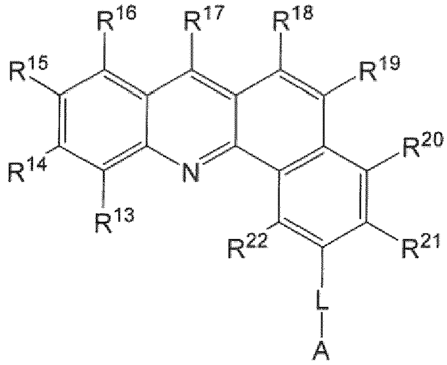

(IV)

wherein

- L is a single bond or selected from the group consisting of substituted or unsubstituted $C_6$ to $C_{12}$ aryl, wherein, if L is substituted, the one or more substituent(s) are independently selected from the group consisting of D, $C_1$ to $C_6$ alkyl, and $C_1$ to $C_6$ alkoxy;
- A is a metal chelating moiety and the metal chelating moiety is selected from the group consisting of substituted or unsubstituted bipyridyl, substituted or unsubstituted terpyridyl, substituted or unsubstituted phenanthroline, and substituted or unsubstituted 1-(pyridin-2-yl)imidazo[1,5-a]pyridine-3-yl;

wherein the one or more substituent(s), if present, are independently selected from the group consisting of D, $C_6$ to $C_{12}$ aryl, $C_3$ to $C_{11}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R_{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, wherein each $C_6$ to $C_{12}$ aryl substituent and each $C_3$ to $C_{11}$ heteroaryl substituent may be substituted with one or more independently selected from the group consisting of D, $C_1$ to $C_4$ alkyl, $C_3$ to $C_{25}$ silyl or halogen;

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and
- $R^7$ and $R^{17}$ are independently selected from the group consisting of substituted or unsubstituted $C_6$ to $C_{18}$ aryl, wherein the one or more substituent(s), if present, are independently selected from the group consisting of D, $C_1$ to $C_4$ alkyl and $C_3$ to $C_{25}$ silyl.

According to one embodiment, the present invention provides an organic electronic device comprising a first

electrode, a second electrode and an organic semiconducting layer, wherein

- the organic semiconducting layer is arranged between the first electrode and the second electrode; and
- the organic semiconducting layer comprises a compound of formula (III) or (IV)

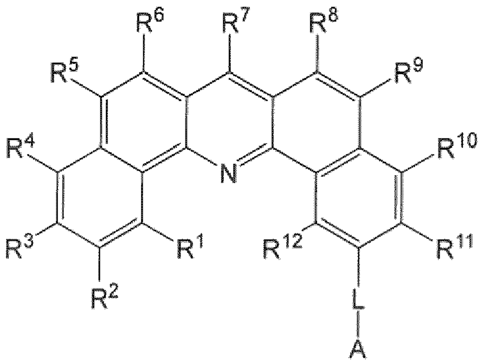
(III)

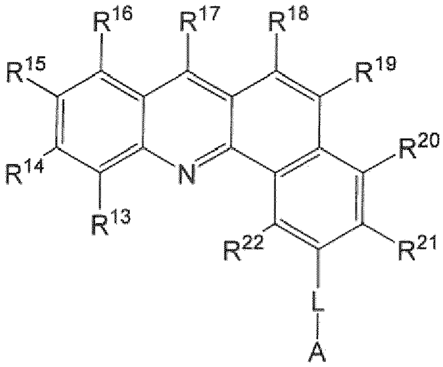
(IV)

wherein

- L is a single bond or selected from the group consisting of substituted or unsubstituted $C_6$ to $C_{12}$ aryl, wherein, if L is substituted, the one or more substituent(s) are each D;
- A is a metal chelating moiety and the metal chelating moiety is substituted or unsubstituted bipyridyl;

wherein the one or more substituent(s), if present, are independently selected from the group consisting of D, $C_1$ to $C_6$ alkyl, $C_1$ to $C_6$ alkoxy, partially or perdeuterated $C_1$ to $C_6$ alkyl, partially or perdeuterated $C_1$ to $C_6$ alkoxy, and $C_3$ to $C_{25}$ silyl;

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perdeuterated $C_1$ to $C_6$ alkyl, partially or perdeuterated $C_1$ to $C_6$ alkoxy, and $C_3$ to $C_{25}$ silyl; and
- $R^7$ and $R^{17}$ are independently selected from the group consisting of substituted or unsubstituted $C_6$ to $C_{10}$ aryl, wherein the one or more substituent(s), if present, are independently selected from the group consisting of D, $C_1$ to $C_4$ alkyl and $C_3$ to $C_{25}$ silyl.

The compound of formula (III) or (IV) may have the formula (III) and may be selected from the following E1 to E7

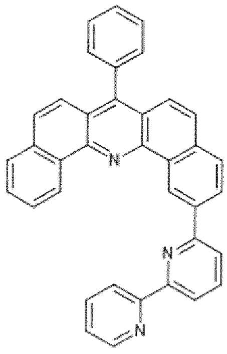
E1

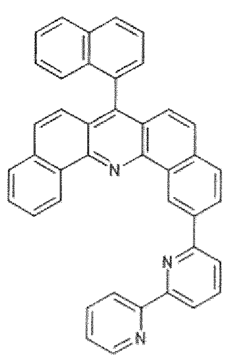
E2

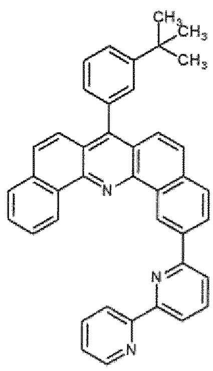
E3

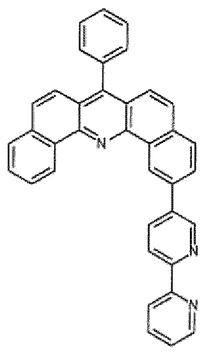
E4

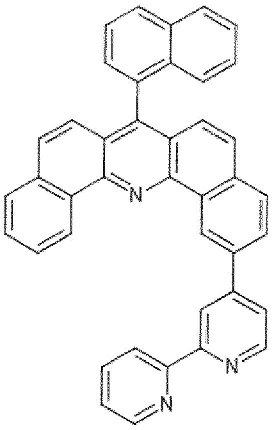 E5 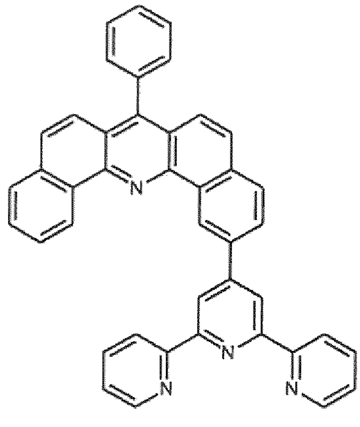 E6 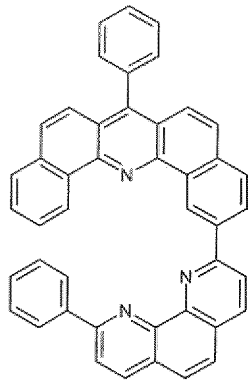 E7.

Compound of formula (V) or (VI)

According to a further aspect, the present invention relates to a compound compound having formula (V) or (VI)

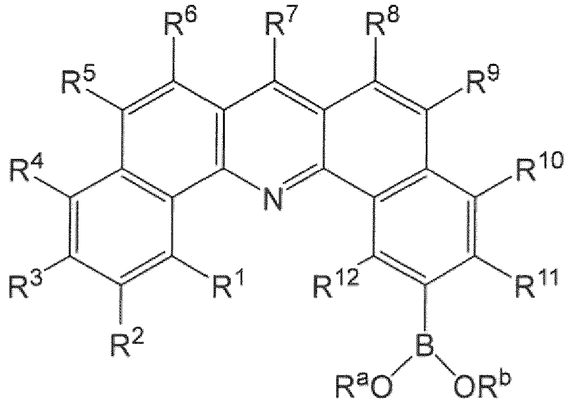 (V) 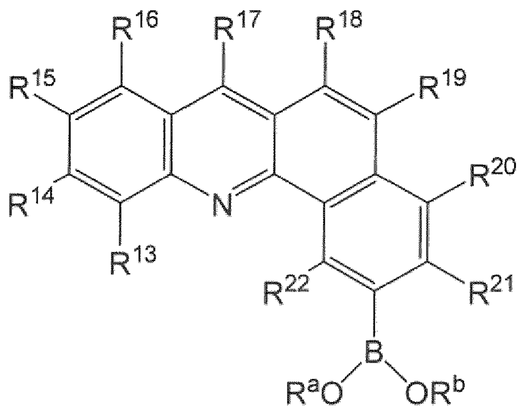 (VI).

For compounds (V) and (VI), $R^1$ to $R^{22}$ are independently selected from the group consisting of H, D, substituted or unsubstituted $C_6$ to $C_{18}$ aryl, substituted or unsubstituted $C_3$ to $C_{17}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy,

- wherein the one or more substituents on $C_6$ to $C_{18}$ aryl and $C_3$ to $C_{17}$ heteroaryl, if present, are independently selected from the group consisting of D, $C_1$ to $C_4$ alkyl, $C_3$ to $C_{25}$ silyl or halogen

The compounds of formulas (V) and (VI) are intermediates in the preparation of the compounds of formulas (I) to (IV). All embodiments described above with respect to $R^1$ to $R^{22}$ for the compounds of formulas (I) and (II) and all embodiments described above with respect to $R^1$ to $R^{22}$ for the compounds of formulas (III) and (IV) are also embodiments for the compounds of formulas (V) and (VI).

$R^a$ and $R^b$ are independently selected from $C_1$ to $C_{22}$ hydrocarbyl. $R^a$ and $R^b$ may be independently selected from $C_1$ to $C_{20}$ hydrocarbyl. $R^a$ and $R^b$ may be independently selected from $C_1$ to $C_{18}$ hydrocarbyl. $R^a$ and $R^b$ may be independently selected from $C_1$ to $C_{16}$ hydrocarbyl. $R^a$ and $R^b$ may be independently selected from $C_1$ to $C_{14}$ hydrocarbyl. $R^a$ and $R^b$ may be independently selected from $C_1$ to $C_{12}$ hydrocarbyl. $R^a$ and $R^b$ may be independently selected from $C_1$ to $C_{10}$ hydrocarbyl. $R^a$ and $R^b$ may be independently selected from $C_1$ to $C_8$ hydrocarbyl. $R^a$ and $R^b$ may be independently selected from $C_1$ to $C_6$ hydrocarbyl. $R^a$ and $R^b$ may be independently selected from $C_1$ to $C_4$ hydrocarbyl. $R^a$ and $R^b$ may be independently selected from $C_2$ to $C_4$ hydrocarbyl. $R^a$ and $R^b$ may be independently $C_3$ hydrocarbyl.

$R^a$ and $R^b$ may be independently selected from $C_1$ to $C_{22}$ alkyl. $R^a$ and $R^b$ may be independently selected from $C_1$ to $C_{20}$ alkyl. $R^a$ and $R^b$ may be independently selected from $C_1$ to $C_{18}$ alkyl. $R^a$ and $R^b$ may be independently selected from

$C_1$ to $C_{16}$ alkyl. $R^a$ and $R^b$ may be independently selected from $C_1$ to $C_{14}$ alkyl. $R^a$ and $R^b$ may be independently selected from $C_1$ to $C_{12}$ alkyl. $R^a$ and $R^b$ may be independently selected from $C_1$ to $C_{10}$ alkyl. $R^a$ and $R^b$ may be independently selected from $C_1$ to $C_8$ alkyl. $R^a$ and $R^b$ may be independently selected from $C_1$ to $C_6$ alkyl. $R^a$ and $R^b$ may be independently selected from $C_1$ to $C_4$ alkyl. $R^a$ and $R^b$ may be independently selected from $C_2$ to $C_4$ alkyl. $R^a$ and $R^b$ may be independently $C_3$ alkyl. $R^a$ and $R^b$ may be each iso-propyl.

$R^a$ and $R^b$ can be selected as set forth above and may be connected with each other via a single bond. This means that a hydrogen atom of $R^a$ and a hydrogen atom of $R^b$ are replaced by the same single bond connecting $R^a$ and $R^b$. For examples, if $R^a$ and $R^b$ are each iso-propyl and are connected with each other via a single bond, the following moiety is formed:

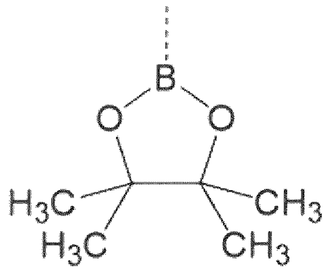

The compound of formula (V) or (VI) may have the formula (V) and may be selected from the following Im1 and Im2

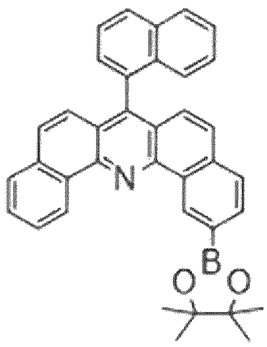

Im1

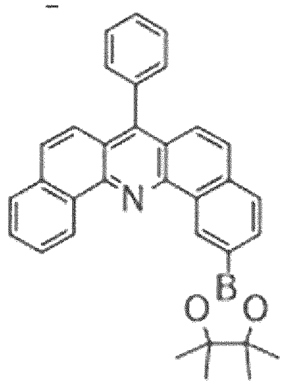

Im2.

Details and definitions of the invention

An organic compound as referred to herein is generally any chemical compound that contains carbon (except some compounds generally referred to as being inorganic, such as carbonates, cyanides, carbon dioxide, diamond etc.). The term organic compound used herein also encompasses compounds such as organometallic compounds, for example metallocenes etc.

If not mentioned else explicitly, all compounds, groups, moieties, substituents etc. shown herein, especially by structural formulas, by systematic names etc. encompass the respective partially and fully deuteriated derivatives thereof.

The term "zero-valent" as used herein refers to a metal in the oxidation state o, i.e. particular to metals from which no electron has been removed. The zero-valent metal may be present in the form of zero-valent atoms, neat metal, alloys etc.

The term "trivalent" as used herein refers to a nitrogen atom with a single bond and a double bond and containing a lone pair of electrons.

The term "hydrocarbyl group" as used herein shall be understood to encompass any organic group comprising carbon atoms, in particular organic groups, such as alkyl, aryl, heteroaryl, heteroalkyl, in particular such groups which are substituents usual in organic electronics.

The term "conjugated system" as used herein refer to a system of alternating $\pi$- and $\sigma$-bonds or a molecule having alternating single and multiple bonds i.e. double bond or a system having one or more two-atom structural units having the $\pi$-bond between its atoms can be replaced by an atom bearing at least one lone electron pair, typically by a divalent O or S atom.

The term "alkyl" as used herein shall encompass linear as well as branched and cyclic alkyl. For example, $C_3$-

alkyl may be selected from n-propyl and iso-propyl. Likewise, $C_4$-alkyl encompasses n-butyl, sec-butyl and t-butyl. Likewise, $C_6$-alkyl encompasses n-hexyl and cyclohexyl.

The subscribed number n in $C_n$ relates to the total number of carbon atoms in the respective alkyl, arylene, heteroarylene or aryl group.

The term "aryl" or "arylene" as used herein shall encompass phenyl ($C_6$-aryl), fused aromatics, such as naphthalene, anthracene, phenanthrene, tetracene etc.. Further encompassed are biphenyl and oligo- or polyphenyls, such as terphenyl, phenyl-substituted biphenyl, phenyl-substituted terphenyl (such as tetraphenyl benzene groups) etc.. "Arylene" respectively "heteroarylene", refers to groups to which two further moieties are attached. In the present specification, the term "aryl group" or "arylene group" may refer to a group comprising at least one hydrocarbon aromatic moiety, and all the elements of the hydrocarbon aromatic moiety may have p-orbitals which form conjugation, for example a phenyl group, a napthyl group, an anthracenyl group, a phenanthrenyl group, a pyrenyl group, a fluorenyl group and the like. Further encompassed are spiro compounds in which two aromatic moieties are connected with each other via a spiro-atom, such as 9,9'-spirobi[9H-fluorene]yl. The aryl or arylene group may include a monocyclic or fused ring polycyclic (i.e., links sharing adjacent pairs of carbon atoms) functional group.

The term "heteroaryl" as used herein refers to aryl groups in which at least one carbon atom is substituted with a heteroatom. The term "heteroaryl" may refer to aromatic heterocycles with at least one heteroatom, and all the elements of the hydrocarbon heteroaromatic moiety may have p-orbitals which form conjugation. The heteroatom may be selected from N, O, S, B, Si, P, Se, preferably from N, O and S. A heteroarylene ring may comprise at least 1 to 3 heteroatoms. Preferably, a heteroarylene ring may comprise at least 1 to 3 heteroatoms individually selected from N, S and/or O. Just as in case of "aryl"/"arylene", the term "heteroaryl" comprises, for example, spiro compounds in which two aromatic moieties are connected with each other, such as spiro[fluorene-9,9'-xanthene]. Further exemplary heteroaryl groups are diazine, triazine, dibenzofurane, dibenzothiofurane, acridine, benzoacridine, dibenzoacridine etc.

The subscripted number n in $C_n$-heteroaryl merely refers to the number of carbon atoms excluding the number of heteroatoms. In this context, it is clear that a $C_3$ heteroarylene group is an aromatic compound comprising three carbon atoms, such as pyrazole, imidazole, oxazole, thiazole and the like.

The term "$C_n$ silyl" refers to a hydrocarbyl group comprising n carbon atoms, wherein at least one carbon atom is replaced with a Si-atom and the group is bound to the remaining structure via a single bond between the remaining structure and the Si-atom.

The term "halogenated" refers to an organic compound in which one hydrogen atom thereof is replaced by a halogen atom. The term "perhalogenated" refers to an organic compound in which all of the hydrogen atoms thereof are replaced by halogen atoms. The meaning of the terms "fluorinated" and "perfluorinated" should be understood analogously.

The term "alkenyl" as used herein refers to a group $-CR^1 = CR^2R^3$ comprising a carbon-carbon double bond.

The term "alkoxy" as used herein refers to a structural fragment of the Formula -OR with R being hydrocarbyl, preferably alkyl or cycloalkyl.

The term "thioalkyl" as used herein refers to a structural fragment of the Formula -SR with R being hydrocarbyl, preferably alkyl or cycloalkyl.

In the present specification, the term single bond refers to a direct bond and vice versa.

In terms of the invention, a group is "substituted with" another group if one of the hydrogen atoms comprised in this group is replaced by another group, wherein the other group is the substituent.

In accordance with the present disclosure, in a formula showing the following binding situation,

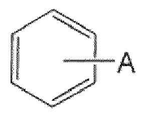

the arbitrary group A may be bound to any suitable binding position. In the following situation, where it is shown that the bond of A crosses more than one ring

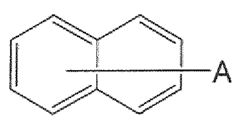

the arbitrary group A may be bound to any suitable binding position of each ring crossed with the bond.

In terms of the invention, the expression "between" with respect to one layer being between two other layers does not exclude the presence of further layers, which may be arranged between the one layer and one of the two other layers. In terms of the invention, the expression "in direct contact" with respect to two layers being in direct contact with each other

means that no further layer is arranged between those two layers. One layer deposited on the top of another layer is deemed to be in direct contact with this layer.

In the context of the present specification the term "essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about ≥ 380 nm to about ≤ 780 nm.

With respect to the inventive organic light emitting device, the compounds mentioned in the experimental part may be most preferred.

The organic electroluminescent device (OLED) may be a bottom- or top-emission device.

Another aspect is directed to a device comprising at least one organic electroluminescent device (OLED). A device comprising organic light-emitting diodes is for example a display or a lighting panel.

In the present invention, the following defined terms, these definitions shall be applied, unless a different definition is given in the claims or elsewhere in this specification.

In the context of the present specification, the term "different" or "differs" in connection with the matrix material means that the matrix material differs in their structural formula.

The energy levels of the highest occupied molecular orbital, also named HOMO, and of the lowest unoccupied molecular orbital, also named LUMO, are measured in electron volt (eV).

The terms "OLED" and "organic light-emitting diode" are simultaneously used and have the same meaning. The term "organic electroluminescent device" as used herein may comprise both organic light emitting diodes as well as organic light emitting transistors (OLETs).

As used herein, "weight percent", "wt.-%", wt96, "percent by weight", "% by weight", and variations thereof refer to a composition, component, substance or agent as the weight of that component, substance or agent of the respective electron transport layer divided by the total weight of the respective electron transport layer thereof and multiplied by 100. It is understood that the total weight percent amount of all components, substances and agents of the respective electron transport layer and electron injection layer are selected such that it does not exceed 100 wt.-%.

As used herein, "volume percent", "vol.-%", "percent by volume", "% by volume", and variations thereof refer to a composition, component, substance or agent as the volume of that component, substance or agent of the respective electron transport layer divided by the total volume of the respective electron transport layer thereof and multiplied by 100. It is understood that the total volume percent amount of all components, substances and agents of the cathode layer are selected such that it does not exceed 100 vol.-96.

All numeric values are herein assumed to be modified by the term "about", whether or not explicitly indicated. As used herein, the term "about" refers to variation in the numerical quantity that can occur. Whether or not modified by the term "about" the claims include equivalents to the quantities.

It should be noted that, as used in this specification and the appended claims, the singular forms "a", "an", and "the" include plural referents unless the content clearly dictates otherwise.

The term "free of", "does not contain", "does not comprise" does not exclude impurities. Impurities have no technical effect with respect to the object achieved by the present invention. The term "free of" a a compound means that such compound/material is not deliberately added to the layer during processing.

Preferably, the semiconducting layer according to the invention and layers in an OLED formed thereof are essentially non-emissive or non-emitting.

The operating voltage, also named U, is measured in Volt (V) at 10 milliAmpere per square centimeter ($mA/cm^2$).

The candela per Ampere efficiency, also named cd/A efficiency is measured in candela per ampere at 10 milliAmpere per square centimeter ($mA/cm^2$).

The external quantum efficiency, also named EQE, is measured in percent (96).

The color space is described by coordinates CIE-x and CIE-y (International Commission on Illumination 1931). For blue emission the CIE-y is of particular importance. A smaller CIE-y denotes a deeper blue color. Efficiency values are compared at the same CIE-y.

The highest occupied molecular orbital, also named HOMO, and lowest unoccupied molecular orbital, also named LUMO, are measured in electron volt (eV).

The term "OLED", "organic light emitting diode", "organic light emitting device", "organic optoelectronic device" and "organic light-emitting diode" are simultaneously used and have the same meaning.

The term "life-span" and "lifetime" are simultaneously used and have the same meaning.

The anode and cathode may be described as anode electrode / cathode electrode or anode electrode / cathode electrode or anode electrode layer / cathode electrode layer.

Room temperature, also named ambient temperature, is 23° C.

Hereinafter, the embodiments are illustrated in more detail with reference to examples. However, the present disclosure is not limited to the following examples. Reference will now be made in detail to the exemplary aspects.

DESCRIPTION OF THE DRAWINGS

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.

FIG. 1 is a schematic sectional view of an organic light emitting diode (OLED), according to an exemplary embodiment of the present invention;

FIG. 2 is a schematic sectional view of an OLED, according to an exemplary embodiment of the present invention;

FIG. 3 is a schematic sectional view of an OLED, according to an exemplary embodiment of the present invention.

FIG. 4 is a schematic sectional view of an OLED comprising a charge generation layer and two emission layers, according to an exemplary embodiment of the present invention.

Hereinafter, the figures are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

FIG. 1 is a schematic sectional view of an organic semiconducting device 100, according to an exemplary embodiment of the present invention. The organic semiconducting device 100 includes a substrate 110, an anode 120, a light emission layer (EML) 125, an organic semiconducting layer according to the invention 160. The organic semiconducting layer comprising or consisting of the compound of formula (I) or (II) according to the invention 160 is formed on the EML 125. Onto the organic semiconductor layer 160, a cathode 190 is disposed.

FIG. 2 is a schematic sectional view of an organic light-emitting diode (OLED) 100, according to an exemplary embodiment of the present invention. The OLED 100 includes a substrate 110, an anode 120, a hole injection layer (HIL) 130, a hole transport layer (HTL) 140, an emission layer (EML) 150, an electron transport layer (ETL) 160. The electron transport layer (ETL) 160 is formed on the EML 150. In this embodiment, the electron transport layer is the organic semiconducting layer according to the invention. Onto the electron transport layer (ETL) 160, an electron injection layer (EIL) 180 is disposed. The cathode 190 is disposed directly onto the electron injection layer (EIL) 180.

Fig. 3 is a schematic sectional view of an OLED 100, according to another exemplary embodiment of the present invention. Fig. 3 differs from Fig. 2 in that the OLED 100 of Fig. 3 comprises an electron blocking layer (EBL) 145 and a hole blocking layer (HBL) 155. Referring to Fig. 3, the OLED 100 includes a substrate 110, an anode 120, a hole injection layer (HIL) 130, a hole transport layer (HTL) 140, an electron blocking layer (EBL) 145, an emission layer (EML) 150, a hole blocking layer (HBL) 155, an electron transport layer (ETL) 160, an electron injection layer (EIL) 180 and a cathode electrode 190. In this embodiment of Fig. 3, the ETL 160 is the organic semiconducting layer comprising the compound of formula (I) or (II) according to the present invention.

Fig. 4 is a schematic sectional view of an OLED 100, according to another exemplary embodiment of the present invention. Fig. 4 differs from Fig. 3 in that the OLED 100 of Fig. 4 further comprises a charge generation layer (CGL) and a second emission layer (151). Referring to Fig. 4, the OLED 100 includes a substrate 110, an anode 120, a first hole injection layer (HIL) 130, a first hole transport layer (HTL) 140, a first electron blocking layer (EBL) 145, a first emission layer (EML) 150, a first hole blocking layer (HBL) 155, a first electron transport layer (ETL) 160, an n-type charge generation layer (n-type CGL) 185, a hole generating layer (p-type charge generation layer; p-type GCL) 135, a second hole transport layer (HTL) 141, a second electron blocking layer (EBL) 146, a second emission layer (EML) 151, a second hole blocking layer (EBL) 156, a second electron transport layer (ETL) 161, a second electron injection layer (EIL) 181 and a cathode 190. In this embodiment of Fig. 4, the n-type charge generation layer (n-type CGL) 185 is the organic semiconducting layer comprising the compound of formula (I) or (II) according to the present invention.

While not shown in Fig. 1, Fig. 2, Fig. 3 and Fig. 4, a sealing layer (capping layer) may further be formed on the

cathode electrodes 190, in order to seal the OLEDs 100. In addition, various other modifications may be applied thereto.

Hereinafter, the embodiments are illustrated in more detail with reference to examples. However, the present disclosure is not limited to the following examples.

Synthesis procedures

**7-(naphthalen-1-yl)-2-(4,4,5,5-tetramethyl-1,3,2-dioxaborolan-2-yl)dibenzo[c,h]acridine (Im1)**

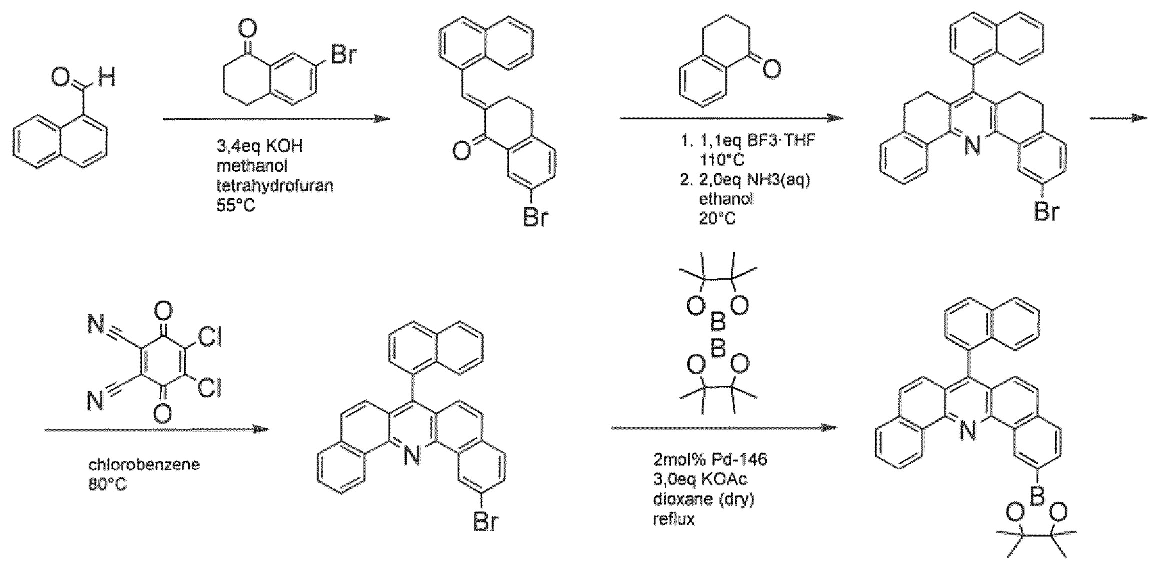


**1st Step. 7-bromo-2-(naphthalen-1-ylmethylene)-3,4-dihydronaphthalen-1(2H)-one**

A three-neck round-bottom flask was flushed with nitrogen and charged with 7-bromo-3,4-dihydronaphthalen-1(2H)-one (CAS 32281-97-3, 1.0 eq, 250 g), 1-naphthaldehyde (CAS 66-77-3, 1.0 eq, 173.5 g), potassium hydroxide (CAS 1310-58-3, 3.4 eq, 211.9 g) and the solids were dissolved in 625 mL methanol. 175 mL tetrahydrofuran were added. The reaction mixture was stirred at 55°C under nitrogen atmosphere over 2 hours and allowed to cool down to room temperature. The formed solid was filtered and washed with methanol and methyl tert-butylether (MTBE). The raw product was dissolved in dichloromethane (DCM), methanol was added and the solid was filtered and washed with methanol. Yield: 359 g (89%).

**2nd Step. 2-bromo-7-phenyl-5,6,8,9-tetrahydrodibenzo[c,h]acridine**

A three-neck round-bottom flask was flushed with nitrogen and charged with 3,4-dihydronaphthalen-1(2H)-one (CAS 529-34-0, 0.97 eq, 117.1 g), 7-bromo-2-(naphthalen-1-ylmethylene)-3,4-dihydronaphthalen-1(2H)-one (product of the first step - no CAS, 1.0 eq, 300 g), boron trifluoride-tetrahydrofuran complex (CAS 462-34-0, 1.1 eq, 130.5 g). The reaction mixture was heated to 110°C and stirred for 18 hours. After cooling down, MTBE was added. Resulting solid was filtered off and washed with MTBE. Ethanol was added to the wet solid material with stirring under a nitrogen atmosphere. The mixture was cooled to 0°C and 33% aqueous ammonia solution (CAS 1336-21-6, 2.0 eq, 114 mL) was added. The slurry was allowed to warm up to room temperature and stirred for 18 hours. The solid was filtered and washed with ethanol. Further purification was done by column chromatography using a mixture of DCM and n-hexane as eluent. White powder. Yield: 74.3 g (18%).

**3rd Step. 2-bromo-7-(naphthalen-1-yl)dibenzo[c,h]acridine**

A three-neck round-bottom flask was flushed with nitrogen and charged with 4,5-dichloro-3,6-dioxocyclohexa-1,4-diene-1,2-dicarbonitrile (CAS 84-58-2, 3.4 eq, 31.6 g), 2-bromo-7-(naphthalen-1-yl)-5,6,8,9-tetrahydrodibenzo[c,h]acridine (product of the previous step - no CAS, 1.0 eq, 20 g). 500 mL deaerated chlorobenzene was added. The reaction mixture was stirred at 80°C under nitrogen atmosphere over 3 days. The formed suspension was filtered hot and the separated solid washed with chlorobenzene. The filtrate was then added to a mixture of methanol and diisopropyl ethyl

amine (DIPEA) and heated to reflux for 1 hour. The resulting solid was filtered and washed with methanol. Yield: 18.6 g (94%).

**4th Step. 7-(naphthalen-1-yl)-2-(4,4,5,5-tetramethyl-1,3,2-dioxaborolan-2-yl)dibenzo[c,h]acridine (Im1)**

A three-neck round-bottom flask was flushed with nitrogen and charged with 4,4,4',4',5,5,5',5'-octamethyl-2,2'-bi(1,3,2-dioxaborolane) (CAS 73183-34-3, 1.3 eq, 13.6 g), 2-bromo-7-(naphthalen-1-yl)dibenzo[c,h]acridine (product of the previous step - no CAS, 1.0 eq, 20.0 g), [1,1'-bis(diphenylphosphino)ferrocene]dichloropalladium(II) (CAS 72287-26-4, 0.02 eq, 0.6 g), potassium acetate (CAS 127-08-2, 3 eq, 12.2 g). 275 mL deaerated dioxane was added. The reaction mixture was stirred at reflux under nitrogen atmosphere overnight. After cooling down to room temperature, a dark solution formed. The solvent was evaporated at low pressure and the resulting crude product was dispersed in methanol. The solid was filtered, washed with methanol and water, dried, dissolved in chloroform and filtered through a silica pad. The solvent was evaporated at low pressure and the resulting solid was stirred in methanol, filtered and washed with methanol. Yield: 16.5 g (75%).

**2-([2,2'-bipyridin]-6-yl)-7-(naphthalen-1-yl)dibenzo[c,h]acridine (E2)**

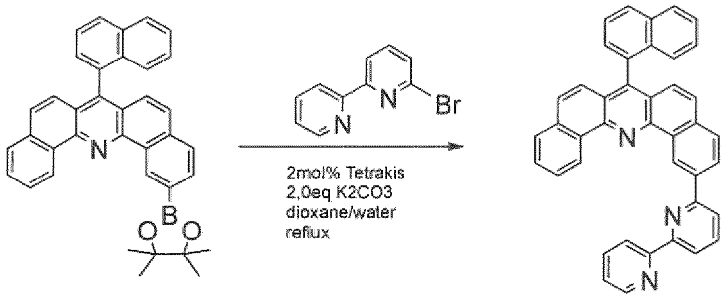


A three-neck round-bottom flask was flushed with nitrogen and charged with 6-bromo-2,2'-bipyridine (CAS 10495-73-5, 1.2 eq, 4.8 g), 7-(naphthalen-1-yl)-2-(4,4,5,5-tetramethyl-1,3,2-dioxaborolan-2-yl)dibenzo[c,h]acridine (Im1) described above (no CAS, 1.0 eq, 9.0 g), tetrakis(triphenylphosphine)palladium(o) (CAS 14221-01-3, 0.02 eq, 0.4 g), potassium carbonate (CAS 584-08-7, 2.0 eq, 4.7 g). A deaerated mixture of 80 mL dioxane and 20 mL water was added. The reaction mixture was stirred at reflux under nitrogen atmosphere overnight and then allowed to cool to room temperature, whereby a grey suspension formed. The solid material was filtered and washed with dioxane, water and methanol. Then, the separated solid raw product was dissolved in hot chlorobenzene and the solution filtered hot through a pad of celite. Methanol was added to the solution with slow stirring, resulting in formation of a solid that was filtered, washed with methanol and dried. Final purification was carried out by high vacuum sublimation. White powder. Yield: 5.1g (52%). ESI-MS: 560 (M+H).

**2-([2,2'-bipyridin]-4-yl)-7-(naphthalen-1-yl)dibenzo[c,h]acridine (E5)**

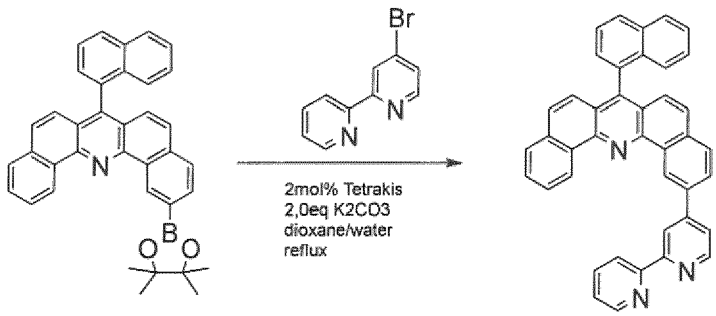


A three-neck round-bottom flask was flushed with nitrogen and charged with 4-bromo-2,2'-bipyridine (CAS 14162-95-9, 1.2 eq, 14.4 g), 7-(naphthalen-1-yl)-2-(4,4,5,5-tetramethyl-1,3,2-dioxaborolan-2-yl)dibenzo[c,h]acridine

(Im1) described above (no CAS, 1.0 eq, 27.0 g), tetrakis(triphenylphosphine)palladium(o) (CAS 14221-01-3, 0.02 eq, 1.2 g), potassium carbonate (CAS 584-08-7, 2.0 eq, 14.1 g). A deaerated mixture of 240 mL dioxane and 60 mL water was added. The reaction mixture was stirred at reflux under nitrogen atmosphere overnight and then allowed to cool to room temperature. A grey suspension formed. The solid material was filtered and washed with dioxane, water and methanol. Then, the separated solid raw product was dissolved in hot chlorobenzene and the solution filtered hot through a pad of celite. Methanol was added to the solution with slow stirring, resulting in the formation of a solid that was filtered, washed with methanol and dried. Final purification was carried out by high vacuum sublimation. Yellow powder. Yield: 18.2 g (64%). ESI-MS: 560 (M+H)

**7-phenyl-2-(4,4,5,5-tetramethyl-1,3,2-dioxaborolan-2-yl)dibenzo[c,h]acridine (Im2)** was synthesized analogously to Im1, using benzaldehyde (CAS 100-52-7) in the first step instead of 1-naphthaldehyde.

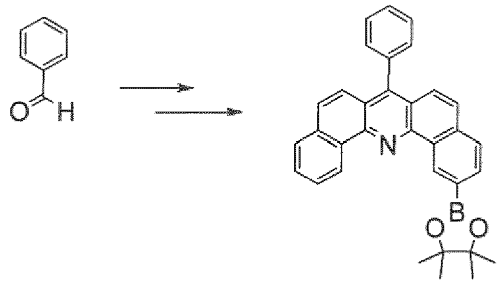

**2-([2,2'-bipyridin]-6-yl)-7-phenyldibenzo[c,h]acridine (E1)**

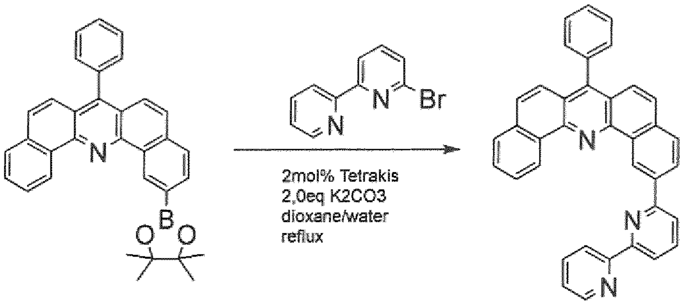


A three-neck round-bottom flask was flushed with nitrogen and charged with 6-bromo-2,2'-bipyridine (CAS 10495-73-5, 1.2 eq, 19.41 g), 7-phenyl-2-(4,4,5,5-tetramethyl-1,3,2-dioxaborolan-2-yl)dibenzo[c,h]acridine (Im2) described above (no CAS, 1.0 eq, 33.12 g), tetrakis(triphenylphosphine)palladium(o) (CAS 14221-01-3, 0.02 eq, 1.6 g), potassium carbonate (CAS 584-08-7, 2.0 eq, 19.0 g). A deaerated mixture of 400 mL dioxane and 100 mL water was added. Reaction was running at reflux under a nitrogen atmosphere overnight. The reaction mixture was stirred at reflux under nitrogen atmosphere overnight and then allowed to cool to room temperature, whereby a grey suspension formed. The solid material was filtered and washed with dioxane, water and methanol. Then, the obtained solid raw product was dissolved in hot chlorobenzene and the solution filtered hot through a pad of celite. Methanol was added to the solution with slow stirring, resulting in formation of a solid that was filtered, washed with methanol and dried. Final purification was carried out by high vacuum sublimation. White powder. Yield: 17.8 g (51%). ESI-MS: 510 (M+H).

**2-([2,2'-bipyridin]-5-yl)-7-phenyldibenzo[c,h]acridine (E4)**

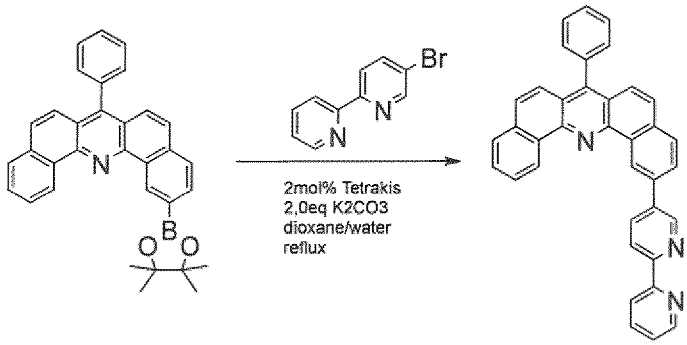


A three-neck round-bottom flask was flushed with nitrogen and charged with 5-bromo-2,2'-bipyridine (CAS 15862-19-8, 1.2 eq, 9.2 g), 7-phenyl-2-(4,4,5,5-tetramethyl-1,3,2-dioxaborolan-2-yl)dibenzo[c,h]acridine (Im2) described above (no CAS, 1.0 eq, 15.7 g), tetrakis(triphenylphosphine)palladium(o) (CAS 14221-01-3, 0.02 eq, 0.8 g), potassium carbonate (CAS 584-08-7, 2.0 eq, 9.0 g). A deaerated mixture of 220 mL dioxane and 65 mL water was added. The reaction mixture was stirred at reflux under nitrogen atmosphere overnight and then allowed to cool to room temperature, whereby a grey suspension formed. The solid material was filtered and washed with dioxane, water and methanol. Then, the obtained solid raw product was dissolved in hot chlorobenzene and the solution filtered hot through a pad of celite. Methanol was added to the solution with slow stirring, resulting in formation of a solid that was filtered, washed with methanol and dried. Final purification was carried out by high vacuum sublimation. Yellowish powder. Yield: 16.8 g (59%). ESI-MS: 510 (M+H).

**2-([2,2':6',2"-terpyridin]-4'-yl)-7-phenyldibenzo[c,h]acridine (E6)**

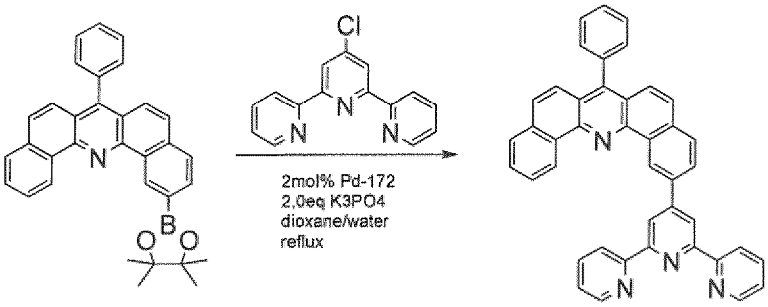


A three-neck round-bottom flask was flushed with nitrogen and charged with 4'-chloro-2,2':6',2"-terpyridine (CAS 128143-89-5, 1.1 eq, 10.9 g), 7-phenyl-2-(4,4,5,5-tetramethyl-1,3,2-dioxaborolan-2-yl)dibenzo[c,h]acridine (Im2) described above (no CAS, 1.0 eq, 18.1 g), chloro(crotyl)(2-dicyclohexylphosphino-2',6'-dimethoxybiphenyl)palladium(II) (CAS 1798781-99-3, 0.02 eq, 0.5 g), potassium phosphate (CAS 7778-53-2, 2.5 eq, 19.7 g). A deaerated mixture of 170 mL THF and 50 mL water was added. The reaction mixture was stirred at reflux under nitrogen atmosphere overnight and then allowed to cool to room temperature. A grey suspension formed. The solid material was filtered and washed with dioxane, water and methanol. Then, the obtained solid raw product was dissolved in hot chlorobenzene and the solution filtered hot through a pad of celite. Methanol was added to the solution with slow stirring, resulting in formation of an orange solid that was filtered, washed with methanol, and recrystallized from toluene. Final purification was carried out by sublimation in high vacuum. Yellowish powder. Yield: 16.2 g (75%). ESI-MS: 587 (M+H).

**7-phenyl-2-(9-phenyl-1,10-phenanthrolin-2-yl)dibenzo[c,h]acridine (E7)**

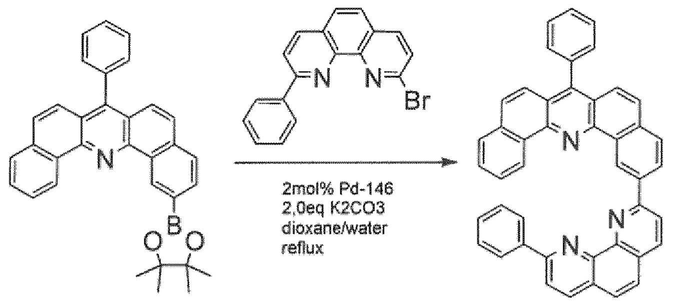


A three-neck round-bottom flask was flushed with nitrogen and charged with 2-bromo-9-phenyl-1,10-phenanthroline (CAS 2042493-16-1, 1.0 eq, 11.0 g), 7-phenyl-2-(4,4,5,5-tetramethyl-1,3,2-dioxaborolan-2-yl)dibenzo[c,h]acridine (Im2) described above (no CAS, 1.0 eq, 15.8 g), [1,1'-bis(diphenylphosphino)ferrocene]dichloropalladium(II) (CAS 72287-26-4, 0.02 eq, 0.5 g), potassium carbonate (CAS 584-08-7, 2.0 eq, 9.1 g). A deaerated mixture of 200 mL dioxane and 30 mL water was added. The reaction mixture was stirred at reflux under nitrogen atmosphere overnight and then allowed to cool to room temperature, whereby a grey suspension formed. The solid material was filtered and washed with dioxane, water and methanol. Then, the obtained solid raw product was dissolved in hot chlorobenzene and the solution filtered hot through a pad of celite. Methanol was added to the solution with slow stirring, resulting in formation of a solid that was filtered, washed with methanol and dried. Final purification was carried out by high vacuum sublimation. Yellow crystalline powder. Yield: 11.4 g (57%). ESI-MS: 610 (M+H).

**7-(3-(tert-butyl)phenyl)-2-(4,4,5,5-tetramethyl-1,3,2-dioxaborolan-2-yl)dibenzo[c,h]acridine (Im3)** was synthesized similar to Im1, using 3-(*tert-butyl*)benzaldehyde (CAS 23039-28-3) in the first step instead of 1-naphthaldehyde.

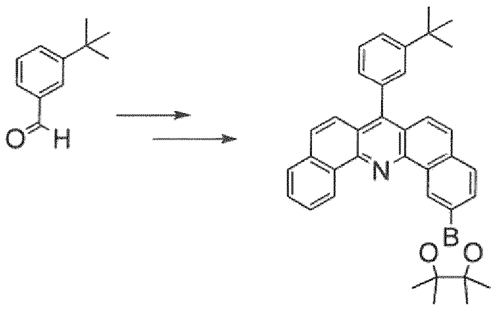

**2-([2,2'-bipyridin]-6-yl)-7-(3-(tert-butyl)phenyl)dibenzo[c,h]acridine (E3)**

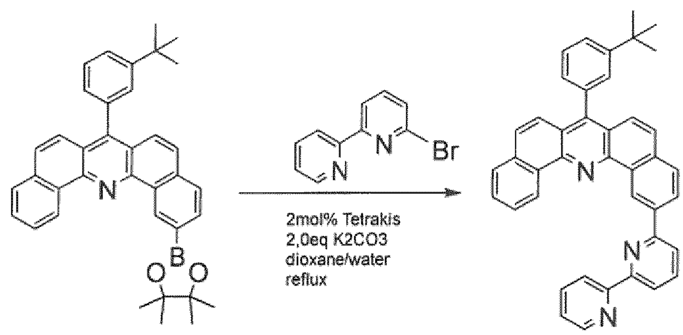


A three-neck round-bottom flask was flushed with nitrogen and charged with 6-bromo-2,2'-bipyridine (CAS 10495-73-5, 1.2 eq, 7.7 g), 7-(3-(tert-butyl)phenyl)-2-(4,4,5,5-tetramethyl-1,3,2-dioxaborolan-2-yl)dibenzo[c,h]acridine (Im3) described above (no CAS, 1.0 eq, 14.6 g), tetrakis(triphenylphosphine)palladium(o) (CAS 14221-01-3, 0.02 eq, 0.6 g), potassium carbonate (CAS 584-08-7, 2.0 eq, 7.5 g). A deaerated mixture of 200 mL dioxane and 50 mL water was added. The reaction mixture was stirred at reflux under nitrogen atmosphere overnight and then allowed to cool to room

temperature, whereby a grey suspension formed. The solid material was filtered and washed with dioxane, water and methanol. Then, the obtained solid raw product was dissolved in hot chlorobenzene and the solution filtered hot through a pad of celite. Methanol was added to the solution with slow stirring, resulting in formation of a solid that was filtered, washed with methanol and dried. Final purification was carried out by high vacuum sublimation. Yellowish powder. Yield: 13.5 g (88%). ESI-MS: 566 (M+H).

Supporting materials for device experiments

F1 is

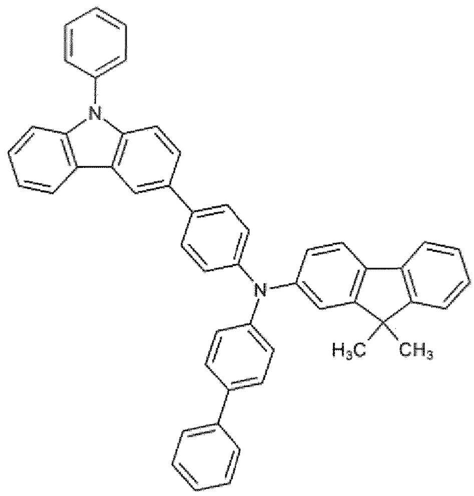

CAS 1242056-42-3
F2 is

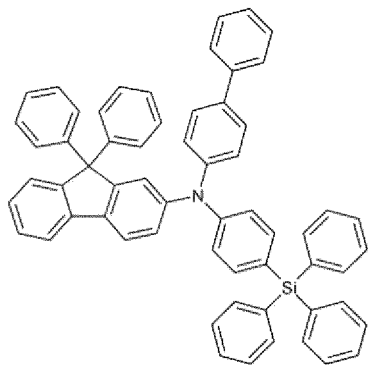

CAS 1613079-70-1
F3 is

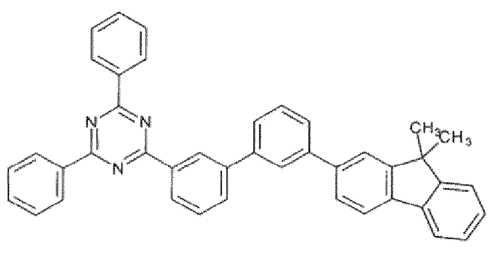

CAS 1955543-57-3
F4 is

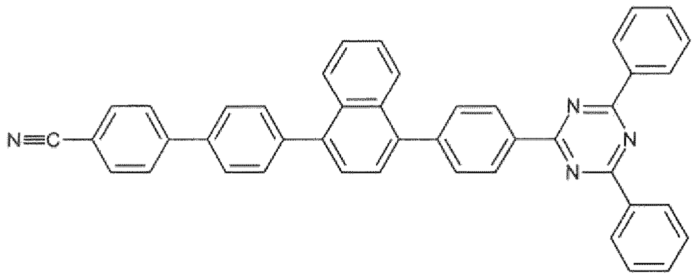

CAS 2032421-37-5
PD-2 is

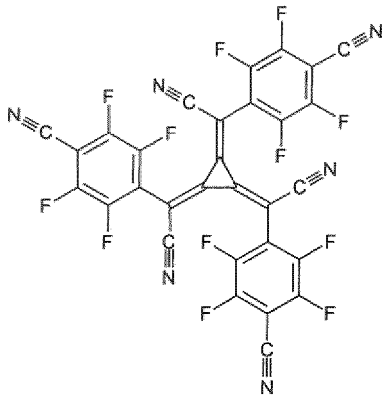

CAS 1224447-88-4
H09 is a blue emitter host and BD200 is a blue emitter dopant, both commercially available from SFC, Korea.
LiQ is lithium 8-hydroxyquinolinolate, CAS 25387-93-3

Tested compounds

Compounds according to the invention:

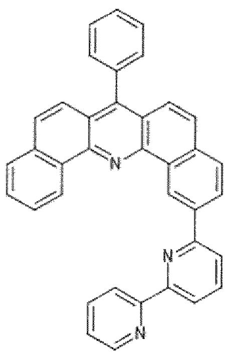
E1

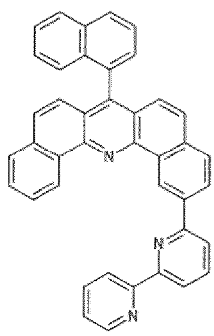
E2

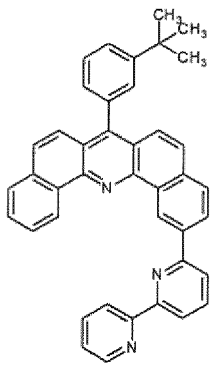
E3

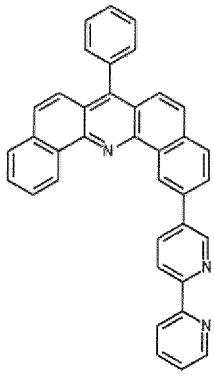
E4
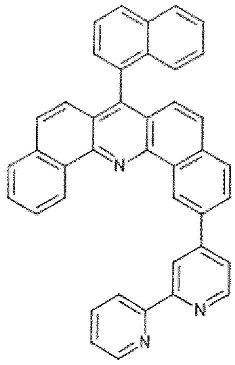
E5

Comparative compound:

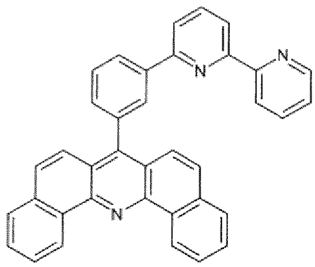
C1

OLED Tests

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in $cd/m^2$ using an Instrument Systems CAS-140CT array spectrometer (calibrated by Deutsche Akkreditierungsstelle (DAkkS)) for each of the voltage values. The cd/A efficiency at 15 mA/cm2 is determined by interpolating the luminance-voltage and current-voltage characteristics, respectively.

In bottom emission devices, the emission is predominately Lambertian and quantified in percent external quantum efficiency (EQE). To determine the efficiency EQE in % the light output of the device is measured using a calibrated photodiode at 15 mA/cm2.

In top emission devices, the emission is forward directed, non-Lambertian and also highly dependent on the mirco-cavity. Therefore, the efficiency EQE will be higher compared to bottom emission devices. To determine the efficiency EQE in % the light output of the device is measured using a calibrated photodiode at 15 $mA/cm^2$.

Lifetime LT of the device is measured at ambient conditions (20°C) and 30 $mA/cm^2$, using a Keithley 2400 sourcemeter, and recorded in hours.

The brightness of the device is measured using a calibrated photo diode. The lifetime LT is defined as the time till the brightness of the device is reduced to 97 % of its initial value.

The increase in operating voltage ΔU is used as a measure of the operational voltage stability of the device. This increase is determined during the LT measurement and by subtracting the operating voltage after 1 hour after the start of operation of the device from the operating voltage after 100 hours.

$$\Delta U=[U100\ h)-U(1h)].$$

The smaller the value of ΔU the better is the operating voltage stability.

Example 1: Blue fluorescent top emission OLED

Blue fluorescent top emission OLEDs with a layer stack in accordance with Table 1 have been prepared.

Table 1:

| **Layer** | **Material** | **c [vol%]** | **d [nm]** |
|---|---|---|---|
| Anode | ITO/Ag/ITO | 100/100/100 | 10/120/10 |
| HIL | F1:PD-2 | 98:2 | 10 |
| HTL1 | F1 | 100 | 29 |
| EBL1 | F2 | 100 | 5 |
| EML1 | H09:BD200 | 97:3 | 19 |
| HBL1 | F3 | 100 | 5 |
| ETL1 | F4:LiQ | 50:50 | 10 |
| nCGL | E1-E5 or C1:Li | 99:1 | 7.5 |
| pCGL | F1:PD-2 | 93:7 | 10 |
| HTL2 | F1 | 100 | 43 |
| EBL2 | F2 | 100 | 5 |
| EML2 | H09:BD200 | 97:3 | 19 |
| HBL2 | F3 | 100 | 5 |
| ETL2 | F4:LiQ | 50:50 | 10 |
| EIL | Yb | 100 | 1.3 |
| cathode | Ag:Mg | 90:10 | 13 |
| capping layer | F1 | 100 | 75 |

The observed device performance is shown in Table 2.

Table 2:

| n-CGL | CCx | CCy | $mA/cm^2$ | U at 1100 nits % | | Eff. % | | LT97 % | | V shift 50-1 % | |
|---|---|---|---|---|---|---|---|---|---|---|---|
| C1 | 0.138 | 0.054 | 6.19 | 7.44 | 100 | 270 | 100 | 75 | 100 | 0.20 | 100 |
| E1 | 0.138 | 0.052 | 6.17 | 6.75 | 91 | 272 | 101 | 102 | 136 | 0.03 | 14 |
| E2 | 0.138 | 0.051 | 6.20 | 6.75 | 91 | 272 | 101 | 99 | 132 | 0.03 | 17 |
| E3 | 0.138 | 0.051 | 6.18 | 6.82 | 92 | 272 | 101 | 102 | 136 | 0.05 | 28 |
| E4 | 0.138 | 0.054 | 5.88 | 7.30 | 98 | 270 | 100 | 87 | 117 | 0.10 | 50 |
| E5 | 0.138 | 0.054 | 5.88 | 7.44 | 100 | 270 | 100 | 79 | 106 | 0.15 | 78 |

In comparison with state-of-art compound C1, the inventive compounds E1-E5 enabled longer lifetime and higher voltage stability.

The features disclosed in the foregoing description and in the dependent claims may, both separately and in any combination thereof, be material for realizing the aspects of the disclosure made in the independent claims, in diverse forms thereof.

## Claims

1. An organic electronic device comprising a first electrode, a second electrode and an organic semiconducting layer, wherein

- the organic semiconducting layer is arranged between the first electrode and the second electrode; and
- the organic semiconducting layer comprises a compound of formula (I) or (II)

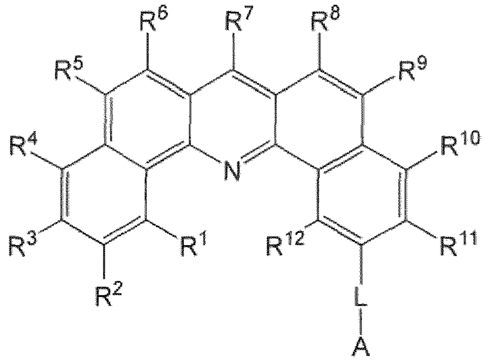
(I)

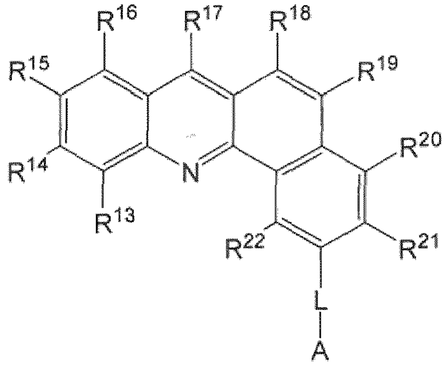
(II)

wherein

- L is a single bond or selected from a substituted or unsubstituted $C_1$ to $C_{36}$ hydrocarbyl and a substituted or unsubstituted $C_2$ to $C_{36}$ heterocyclic group,

  - wherein, if L is substituted, the one or more substituent(s) are independently selected from the group consisting of D, substituted or unsubstituted $C_6$ to $C_{12}$ aryl, substituted or unsubstituted $C_3$ to $C_{11}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, CN or $PY(R^{13})_2$, wherein Y is selected from O, S or Se, preferably O, and $C_3$ to $C_{25}$ silyl, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, and $C_3$ to $C_{25}$ silyl,
  - wherein each $C_6$ to $C_{12}$ aryl substituent and each $C_3$ to $C_{11}$ heteroaryl substituent on L may be substituted with one or more independently selected from the group consisting of D, $C_1$ to $C_4$ alkyl, $C_3$ to $C_{25}$ silyl or halogen;

- A is a metal chelating structural moiety;
- $R^1$ to $R^{22}$ are independently selected from the group consisting of H, D, substituted or unsubstituted $C_6$ to $C_{18}$ aryl, substituted or unsubstituted $C_3$ to $C_{17}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy,
- wherein the one or more substituents on $C_6$ to $C_{18}$ aryl and $C_3$ to $C_{17}$ heteroaryl, if present, are independently selected from the group consisting of D, $C_1$ to $C_4$ alkyl, $C_3$ to $C_{25}$ silyl or halogen.

**2.** The organic electronic device according to claim 1, wherein the metal chelating moiety comprises 2 to 4 atoms each having a free electron pair.

**3.** The organic electronic device according to claim 1, wherein the atoms having a free electron pair are independently selected from the group consisting of O, N, S and P.

**4.** The organic electronic device according to any of the preceding claims, wherein the metal chelating moiety is selected from the group consisting of substituted or unsubstituted bipyridyl, substituted or unsubstituted terpyridyl, substituted or unsubstituted phenanthroline, and substituted or unsubstituted 1-(pyridin-2-yl)imidazo[1,5-a]pyridine-3-yl; wherein the one or more substituent(s), if present, are independently selected from the group consisting of D, $C_6$ to $C_{12}$ aryl, $C_3$ to $C_{11}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$

alkyl, partially or perfluorinated $C_1$ to $C_6$ alkoxy, partially or perdeuterated $C_1$ to $C_6$ alkyl, partially or perdeuterated $C_1$ to $C_6$ alkoxy, wherein each $C_6$ to $C_{12}$ aryl substituent and each $C_3$ to $C_{11}$ heteroaryl substituent may be substituted with one or more independently selected from the group consisting of D, $C_1$ to $C_4$ alkyl, $C_3$ to $C_{25}$ silyl or halogen.

**5.** The organic electronic device according to any of the preceding claims, wherein the metal chelating moiety is substituted or unsubstituted bipyridyl,
wherein the one or more substituent(s) are independently selected from the group consisting of D, $C_6$ to $C_{12}$ aryl, $C_3$ to $C_{11}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, wherein each $C_6$ to $C_{12}$ aryl substituent and each $C_3$ to $C_{11}$ heteroaryl substituent may be substituted with one or more independently selected from the group consisting of D, $C_1$ to $C_4$ alkyl, $C_3$ to $C_{25}$ silyl or halogen.

**6.** The organic electronic device according to any of the preceding claims, wherein L is a single bond or selected from the group consisting of substituted or unsubstituted $C_6$ to $C_{18}$ aryl,
wherein, if L is substituted, the one or more substituent(s) are independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, and partially or perdeuterated $C_1$ to $C_6$ alkoxy.

**7.** The organic electronic device according to any of the preceding claims, wherein

- $R^1$ to $R^6$, $R^8$ to $R^{16}$ and $R^{18}$ to $R^{22}$ are independently selected from the group consisting of H, D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; and
- $R^7$ and $R^{17}$ are independently selected from the group consisting of substituted or unsubstituted $C_6$ to $C_{18}$ aryl and substituted or unsubstituted $C_3$ to $C_{17}$ heteroaryl, wherein the one or more substituent(s), if present, are independently selected from the group consisting of D, $C_1$ to $C_4$ alkyl and $C_3$ to $C_{25}$ silyl.

**8.** The organic electronic device according to any of the preceding claims, wherein the organic semiconducting layer further comprises an electrical n-dopant.

**9.** The organic electronic device according to claim 8, wherein the electrical n-dopant is an elemental metal, a metal salt or a metal complex.

**10.** The organic electronic device according to any of the preceding claims, wherein the organic semiconducting layer is an electron transport layer, an electron injection layer, or an electron generating layer.

**11.** The organic electronic device according to any of the preceding claims, wherein the organic electronic device is an organic light emitting diode.

**12.** The organic electronic device according to claim 10 or 11, wherein the organic electronic device further comprises a first emission layer and a second emission layer and the organic semiconducting layer is arranged between the first emission layer and the second emission layer.

**13.** A display device comprising the organic electronic device according to claim 11 or 12.

**14.** A compound of formula (III) or (IV)

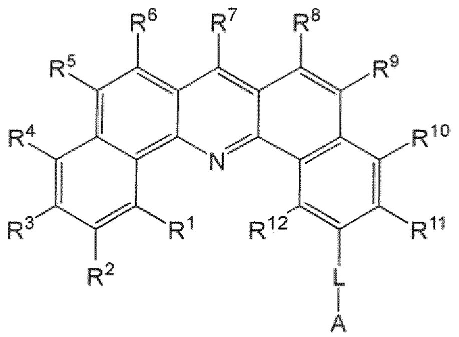
(III)

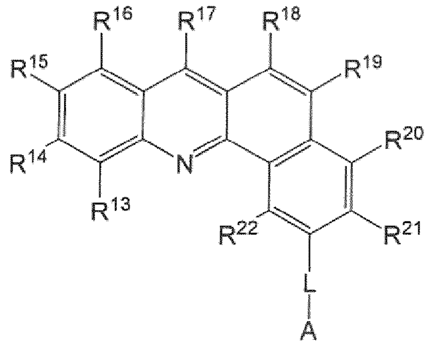
(IV)

wherein

- L is a single bond or selected from a substituted or unsubstituted $C_1$ to $C_{36}$ hydrocarbyl and a substituted or unsubstituted $C_2$ to $C_{36}$ heterocyclic group,

  - wherein, if L is substituted, the one or more substituent(s) are independently selected from the group consisting of D, substituted or unsubstituted $C_6$ to $C_{12}$ aryl, substituted or unsubstituted $C_3$ to $C_{11}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy,
  - wherein each $C_6$ to $C_{12}$ aryl substituent and each $C_3$ to $C_{11}$ heteroaryl substituent on L may be substituted with one or more independently selected from the group consisting of D, $C_1$ to $C_4$ alkyl, $C_3$ to $C_{25}$ silyl or halogen;

- A is a metal chelating structural moiety;
- $R^1$ to $R^{22}$ are independently selected from the group consisting of H, D, substituted or unsubstituted $C_6$ to $C_{18}$ aryl, substituted or unsubstituted $C_3$ to $C_{17}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R^{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy,

  - wherein the one or more substituents on $C_6$ to $C_{18}$ aryl and $C_3$ to $C_{17}$ heteroaryl, if present, are independently selected from the group consisting of D, $C_1$ to $C_4$ alkyl, $C_3$ to $C_{25}$ silyl or halogen;

wherein the following compound is excluded

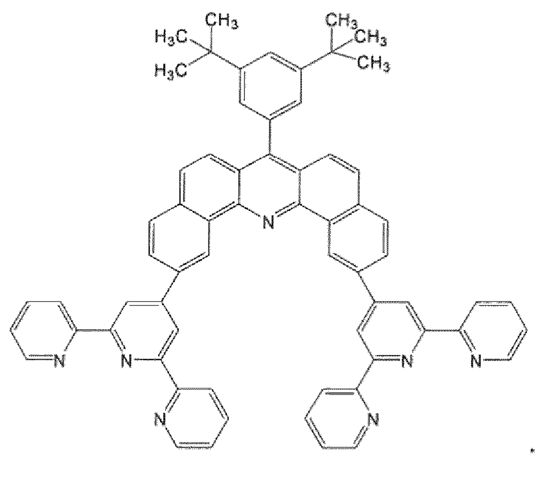

**15.** A compound having formula (V) or (VI)

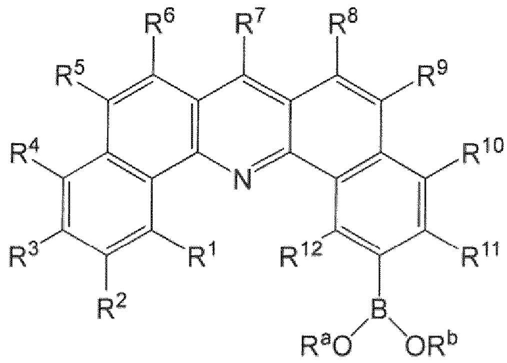 (V)

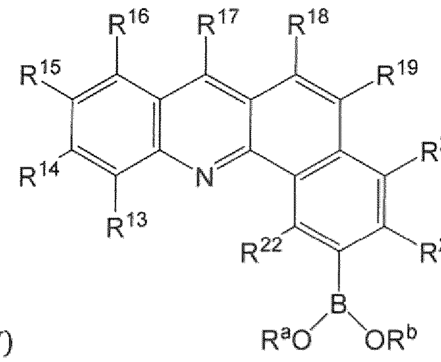 (VI)

wherein

- $R^1$ to $R^{22}$ are independently selected from the group consisting of H, D, substituted or unsubstituted $C_6$ to $C_{18}$ aryl, substituted or unsubstituted $C_3$ to $C_{17}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy, halogen, $C_3$ to $C_{25}$ silyl, CN or $PY(R^{13})_2$, wherein Y is selected from O, S or Se, preferably O, and $R_{13}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy,

  - wherein the one or more substituents on $C_6$ to $C_{18}$ aryl and $C_3$ to $C_{17}$ heteroaryl, if present, are independently selected from the group consisting of D, $C_1$ to $C_4$ alkyl, $C_3$ to $C_{25}$ silyl or halogen;

- $R^a$ and $R^b$ are independently selected from $C_1$ to $C_{22}$ hydrocarbyl, wherein $R^a$ and $R^b$ can be connected with each other via a single bond.

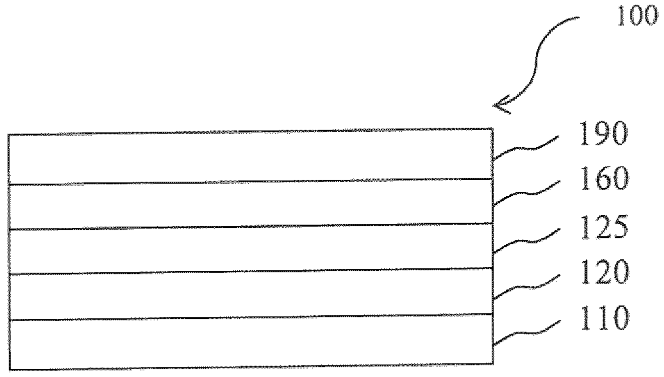


Fig.1

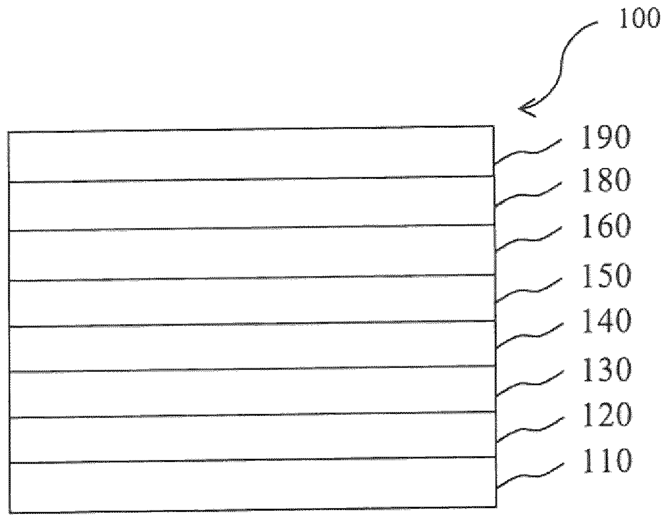


Fig.2

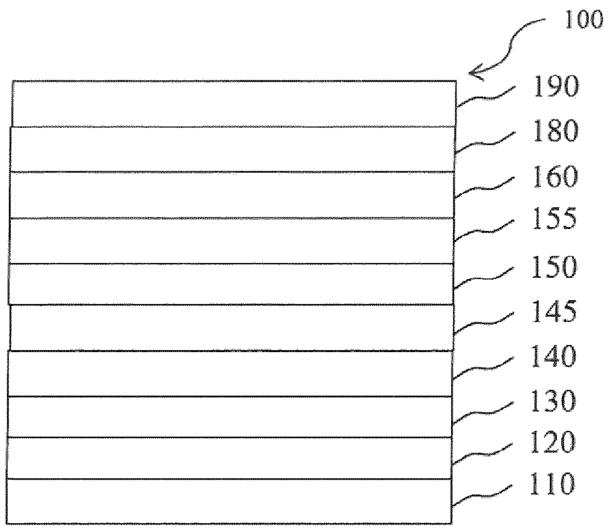
100
190
180
160
155
150
145
140
130
120
110

Fig.3

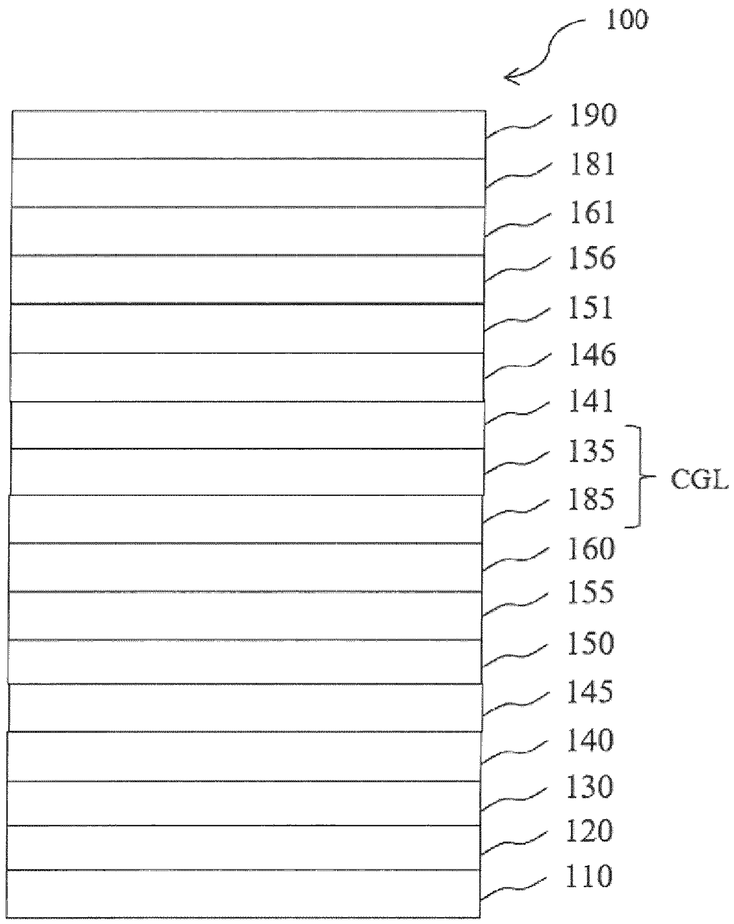
100
190
181
161
156
151
146
141
135
185
CGL
160
155
150
145
140
130
120
110

Fig.4

Europäisches Patentamt
European Patent Office
Office européen des brevets

# EUROPEAN SEARCH REPORT

Application Number
EP 24 22 1740

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y<br>A | KR 2015 0124000 A (DUK SAN NEOLUX CO LTD [KR]) 5 November 2015 (2015-11-05)<br>* paragraph [0090]; claims; figure 1; example 1; compounds 7-1 to 7-8, 7-14 *<br>----- | 1-3,6-15<br>7,15<br>4,5 | INV.<br>C09K11/06<br>H10K50/11<br>H10K85/30<br>H10K85/60 |
| Y | EP 3 147 962 A1 (NOVALED GMBH [DE]) 29 March 2017 (2017-03-29)<br>* table 4; compounds ETM-14, ETM-16, ETM-36 *<br>----- | 7 | |
| Y | US 2014/332790 A1 (FADHEL OMRANE [DE] ET AL) 13 November 2014 (2014-11-13)<br>* pages 41-42; table 1 *<br>----- | 7,15 | |
| | | | TECHNICAL FIELDS SEARCHED (IPC) |
| | | | C09K<br>H05B<br>H10K |

The present search report has been drawn up for all claims

1

| Place of search | Date of completion of the search | Examiner |
|---|---|---|
| The Hague | 15 May 2025 | Schoenhentz, Jérôme |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
..........
& : member of the same patent family, corresponding document

EPO FORM 1503 03.82 (P04C01)

# ANNEX TO THE EUROPEAN SEARCH REPORT ON EUROPEAN PATENT APPLICATION NO.

EP 24 22 1740

This annex lists the patent family members relating to the patent documents cited in the above-mentioned European search report. The members are as contained in the European Patent Office EDP file on
The European Patent Office is in no way liable for these particulars which are merely given for the purpose of information.

15-05-2025

| Patent document cited in search report | Publication date | Patent family member(s) | Publication date |
|---|---|---|---|
| KR 20150124000 A | 05-11-2015 | NONE | |
| EP 3147962 A1 | 29-03-2017 | CN 108352456 A | 31-07-2018 |
| | | EP 3147961 A1 | 29-03-2017 |
| | | EP 3147962 A1 | 29-03-2017 |
| | | JP 6885931 B2 | 16-06-2021 |
| | | JP 2018534768 A | 22-11-2018 |
| | | KR 20180059529 A | 04-06-2018 |
| | | US 2019058123 A1 | 21-02-2019 |
| | | WO 2017055264 A1 | 06-04-2017 |
| US 2014332790 A1 | 13-11-2014 | CN 104247070 A | 24-12-2014 |
| | | CN 107434813 A | 05-12-2017 |
| | | EP 2786435 A1 | 08-10-2014 |
| | | EP 3561876 A1 | 30-10-2019 |
| | | JP 6170501 B2 | 26-07-2017 |
| | | JP 2015506092 A | 26-02-2015 |
| | | KR 20140121389 A | 15-10-2014 |
| | | TW 201322522 A | 01-06-2013 |
| | | US 2014332790 A1 | 13-11-2014 |
| | | WO 2013079217 A1 | 06-06-2013 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2005086251 A
- EP 1837926 B1
- WO 2007107306 A
- WO 2007107356 A
- EP 2722908 A1
- EP 1970371 A1
- WO 2013079217 A1

### Non-patent literature cited in the description


- **YASUHIKO SHIROTA** ; **HIROSHI KAGEYAMA**. *Chem. Rev.*, 2007, vol. 107, 953-1010
- *CHEMICAL ABSTRACTS*, 343313-85-9
- *CHEMICAL ABSTRACTS*, 32281-97-3
- *CHEMICAL ABSTRACTS*, 1310-58-3
- *CHEMICAL ABSTRACTS*, 529-34-0
- *CHEMICAL ABSTRACTS*, 462-34-0
- *CHEMICAL ABSTRACTS*, 1336-21-6
- *CHEMICAL ABSTRACTS*, 84-58-2
- *CHEMICAL ABSTRACTS*, 73183-34-3
- *CHEMICAL ABSTRACTS*, 72287-26-4
- *CHEMICAL ABSTRACTS*, 127-08-2
- *CHEMICAL ABSTRACTS*, 10495-73-5
- *CHEMICAL ABSTRACTS*, 14221-01-3
- *CHEMICAL ABSTRACTS*, 584-08-7
- *CHEMICAL ABSTRACTS*, 14162-95-9
- *CHEMICAL ABSTRACTS*, 15862-19-8
- *CHEMICAL ABSTRACTS*, 128143-89-5
- *CHEMICAL ABSTRACTS*, 1798781-99-3
- *CHEMICAL ABSTRACTS*, 7778-53-2
- *CHEMICAL ABSTRACTS*, 2042493-16-1
- *CHEMICAL ABSTRACTS*, 1242056-42-3
- *CHEMICAL ABSTRACTS*, 1613079-70-1
- *CHEMICAL ABSTRACTS*, 1955543-57-3
- *CHEMICAL ABSTRACTS*, 2032421-37-5
- *CHEMICAL ABSTRACTS*, 1224447-88-4
- *CHEMICAL ABSTRACTS*, 25387-93-3